# EUROPÄISCHE PATENTSCHRIFT

(11) **EP 0 305 461 B1**
(45) Veröffentlichungstag und Bekanntmachung des Hinweises auf die Patenterteilung: **07.01.1993**
(21) Anmeldenummer: 88902452.7
(22) Anmeldetag: 10.03.1988
(51) Int. Cl.: C30B 25/02, C30B 25/12, C30B 25/14, C30B 25/16, C30B 35/00

(54) **EPITAXIEANLAGE**
EPITAXIAL INSTALLATION
INSTALLATION D'APPLICATION DE COUCHES EPITAXIALES

(30) Priorität: 10.03.1987 DE 3707672
(43) Veröffentlichungstag der Anmeldung: 08.03.1989
(73) Patentinhaber: SITESA S.A., CH-6710 Biasca (CH)
(72) Erfinder: DAN, Jean-Pierre, CH-6712 Malvaglia-Chiesa (CH); DE BONI, Eros, CH-6745 Giornico (CH); FREY, Peter, CH-6612 Ascona (CH); IFANGER, Johann, CH-6622 Ronco s/Ascona (CH)
(74) Vertreter: Blum, Rudolf Emil Ernst
(86) Internationale Anmeldenummer: EP8800188
(87) Internationale Veröffentlichungsnummer: WO8807096

(56) Entgegenhaltungen:
- EP-A- 0 085 397
- EP-A- 0 147 967
- DE-A- 3 204 436
- US-A- 4 322 592
- US-A- 4 632 060
- US-A- 4 638 762
- JOURNAL OF THE ELECTROCHEMICAL SOCIETY, Band 132, Nr. 3, März 1985, Manchester, NH, US; J.L.TANDON et al.: "Large-scale growth of GaAs epitaxial layers by metal organic chemical vapor deposition" pages 662-668
- SOLID STATE TECHNOLOGY, Band 28, Nr. 6, Juni 1985, Port-Washington, NY, US; R.E.LOGAR et al.: "Silicon epitaxial processing techniques for ultra-low defect densities" pages 133-136

## Beschreibung

Die Erfindung betrifft eine Epitaxieanlage zum Aufbringen von halbleitenden Schichten auf halbleitende Wafer nach dem Epitaxieverfahren.

Mit derartigen Anlagen können bekanntlich fehlerfreie Schichten von beispielsweise reinem Silicium in perfekter kristalliner Anordnung und/oder wahlweise p- oder n-leitende Siliciumschichten epitaktisch auf eine geeignete Unterlage, hier Silicium, aufgebracht werden. Diese Schichten bilden gewissermaßen das Gerüst für hochintegrierte Schaltkreise. Als Ausgangsmaterial für diese kristallin perfekten Schichten dienen sogenannte hochreine, hier siliciumhaltige, Prozeßgase, denen gegebenenfalls Spuren von p- oder n-Dotierungsstoffen, beispielsweise Arsen- oder Phosphorverbindungen beigemengt sind. Das Silicium und die Dotierungselemente werden in der Reaktionskammer auf der Oberfläche von Wafern nach dem CVD-Verfahren niedergeschlagen. Die Wafer sind in Ausbuchtungen des Trägers aus Siliciumcarbid-beschichtetem Graphit eingesetzt, der auf eine Temperatur von ca. 1050°C aufgeheizt ist. Der Träger wird auch Suszeptor genannt. Bei den Wafern handelt es sich um dünne, parallel zur Gitterebene eines Silicium-Einkristalls geschnittene Plättchen, die eine mit genau der Gitterkonstante gerasterte, perfekte Oberflächen-Struktur aufweisen. Diese Oberflächenstruktur zwingt die aus der Gasphase auf die Wafer abgeschiedenen Siliciumatome in die zum Aufbau von Halbleiterschichten erforderliche perfekte kristalline Ordnung.

Der soeben kurz skizzierte Prozeß zur Herstellung von Halbleiter-Ausgangsmaterial mit Hilfe der Gasphasen-Epitaxie erfordert eine hochentwickelte Technologie sowohl für die Beheizung des Waferträgers wie für die Strömungsführung der Prozeß- und Spülgase. Dabei versteht es sich von selbst, daß das außerhalb der Reaktionskammer stattfindende Be- und Entladen des Waferträgers mit den empfindlichen dünnen Wafern unter Reinstluftbedingungen in einem dafür speziell präparierten Raum der Epitaxieanlage durchgeführt werden muß. Neueste Entwicklungen auf diesem Gebiete zielen dahin, das Hantieren mit den Wafern sowie das Beschicken der Reaktionskammer mit dem Waferträger ferngesteuert, ohne den direkten Eingriff von Bedienpersonen auszuführen.

Bekannte Anlagen vom eingangs genannten Typ zur Durchführung der Gasphasen-Epitaxie werden zwar bereits erfolgreich zur Herstellung von Halbleiterausgangsmaterial eingesetzt, sind jedoch noch in vielen Punkten verbesserungsfähig. So gilt es den Wirkungsgrad der bisher verwendeten Induktionsheizungen ebenso zu verbessern wie deren Verträglichkeit für das Bedienungspersonal. Auf dem Gebiet der Fernsteuerung der eingangs genannten Epitaxieanlage stehen noch Verbesserungen hinsichtlich der Benutzerfreundlichkeit, der vollautomatischen Be- und Entladung der Waferträger und von Steuerroutinen aus, mit denen beim Prozessablauf auftretende Fehlfunktionen beherrscht werden können. Hierbei steht die Sicherheit für das Bedienungspersonal bei auftretenden Fehlfunktionen sowie ein Sicherstellen von bereits teilweise beschichteten Wafern im Vordergrund.

Das noch zu lösende vordringlichste Problem bei der Gasphasen-Epitaxie unter industriellen Grosserienbedingungen betrifft jedoch die zunehmend steigenden Anforderungen an die Beschichtungsqualität, die bei bekannten Anlagen des eingangs genannten Typs aufgrund von in der Anlage vorhandenen, oder beim Beschichtungsprozess erzeugten unerwünschten Partikeln noch zu wünschen übrig lässt. Problematisch ist es dabei vor allem, dass diese unerwünschten Fremdpartikel auf die Waferoberflächen gelangen können und damit die gewünschte kristalline Anordnung beim Aufbau der Epitaxieschichten stören.

Es sind Epitaxie-Anlagen bekannt, die eingerichtet sind, um eine sehr hohe Reinheit der aufgetragenen Schicht zu gewährleisten, beziehungsweise um eine kleine äusserst genau dosierte Beimischung von Dotierungsstoffen sicherzustellen. Die US-A- 4 638 762 sieht innerhalb des Reaktors schraubenförmige Leitflächen vor, um den Gasstrom optimal zu führen. Im J. Electrochem.Soc. 132/3 (3/1985), S.662-668 werden ganz allgemein und anhand von Versuchen die notwendigen Bedingungen für das Aufdampfen einer befriedigenden Halbleiterschicht beschrieben. Des weiteren ist es aus der DE-A-4 632 060 bekannt, Gas-Anteile, welche vor ihrem Einlass in den Reaktor mit mechanisch arbeitenden Teilen (Zahnräder und dergleichen) in Berührung kamen, und daher verunreinigt sein können, weitgehend in das Innere des Wafer-Trägers zu leiten, so dass sie zu dessen Kühlung beitragen können, ohne über die Oberfläche des Wafer zu streichen und diese möglicherweise zu verunreinigen. Diese und andere bekannte Apparaturen weisen meist eine im wesentlichen zylindrische Reaktionskammer mit einem darin befindlichen, zylindrischen oder kegelstumpfförmigen Wafer-Träger auf, entlang dessen Oberfläche die Gase von oben nach unten strömen. Dieser grundsätzliche Aufbau ist im wesentlichen adäquat, lässt aber angesichts der erstreckten Reinheit noch viele Fragen bezüglich der Zu- und Abfuhr von Arbeits- und Spülgasen, bei der gegenseitigen Bewegung von verschiedenen Teilen der Anlage beim Oeffnen und Schliessen der Reaktionskammer, beim Transport der Wafer zum Träger und von diesem weg, usw. offen.

Die vorliegende Erfindung strebt deshalb eine Verbesserung der eingangs genannten gattungsgemässen Epitaxieanlage an, wobei insbesondere unter weitestgehender Beibehaltung von deren bisherigen Vorteilen eine Erhöhung der Gleichmässigkeit und der Reinheit der Epitaxieschicht angestrebt wird.

Diese Aufgabe wird durch die in Anspruch 1 definierte Anlage gelöst.

Insbesondere können sämtliche Gasströme in der Anlage so gesteuert werden, dass unerwünschte mikroskopische Partikel von der Oberfläche des Trägers und damit von der zu beschichtenden Waferoberfläche ferngehalten werden, und zwar unabhängig davon, in welcher Stellung sich der Waferträger befindet, nämlich in Arbeitsstellung, innerhalb der Reaktionskammer oder ausserhalb derselben in der Ladezone oder in einer Stellung zwischen der Ladezone und der Anordnung innerhalb der Reaktionskammer.

Im nachfolgenden sollen zunächst die mit der Erfindung erzielbaren Vorteile im Zusammenhang mit der Überführung des Waferträgers zwischen seiner Stellung innerhalb der Reaktionskammer und der Ladezone dargestellt werden. Lediglich zur größeren Anschaulichkeit soll dabei Bezug genommen werden auf eine im wesentlichen glockenförmige Reaktionskammer mit einem pyramidenstumpfförmigen Waferträger, der zusammen mit dem Kammerboden mittels einer speziellen Einrichtung in die Ladezone überführbar ist. Derartige Waferträger in Form eines endseitig abgeplatteten Vielflachs sind an sich bereits bekannt und weisen an ihrem schräg verlaufenden Flächenausbuchtungen zur Aufnahme von Wafern auf. Die Beschickung der glockenförmigen Reaktionskammer mit Prozeß- und Spülgasen erfolgt vom oberen Teil der Kammer aus, wobei diese Gase im Bereich der Kammerbasis abgezogen werden.

Um nun beim Beladen des Waferträgers sowie beim Überführen des Waferträgers aus der Ladezone in die Reaktionskammer hinein und umgekehrt unerwünschte Fremdkörper in Form mikroskopisch kleiner Teilchen von den zu beschichtenden Waferoberflächen fernzuhalten, ist es erfindungsgemäß vorgesehen, den Waferträger beim Transport zwischen seiner Arbeitsstellung und der Beladestellung in der Ladezone sowie bei seinem vorübergehenden Verbleib in der Ladezone mit einer laminaren Schutzgasströmung zu umgeben, die im Falle eines pyramidenstumpfförmigen Waferträgers diesen vorzugsweise in vertikaler Richtung vom verjüngten oberen zum erweiterten unteren Ende hin umströmt und damit in der umgebenden Reinluftatmosphäre vorhandene Restpartikel wirkungsvoll davon abhält, auf die Trägeroberfläche und damit auf die Wafer zu gelangen. Die Schutzgasströmung ist deshalb im wesentlichen laminar einzustellen, um eine Wirbelbildung in Nachbarschaft des Waferträgers zu verhindern, durch welche Partikel aus der Umgebung auf die Trägeroberfläche transportiert werden könnten.

Vorteilhafterweise ist die Strömung der Reinluftatmosphäre zumindest im Bereich der Ladezone richtungsmäßig an die Schutzgasströmung angepaßt, d.h. daß im Falle einer vertikal von oben nach unten geführten laminaren Schutzgasströmung die diesen laminaren Strömungsmantel umgebende Reinluft ebenfalls vertikal von oben nach unten und damit im wesentlichen parallel zum Schutzgasstrom verläuft.

Gemäß einer vorteilhaften Ausgestaltung der Erfindung ist es vorgesehen, den laminaren Schutzgasstrom mit Hilfe des Spülgases zu erzeugen, das der Reaktionskammer über den Gasmischer zugeführt wird. Damit läßt sich eine Schutzgashülle für den Waferträger beginnend mit der Ausfahrt des Trägers aus der Reaktionskammer gewährleisten, wobei die Einrichtung zur Überführung des Waferträgers aus der Arbeitsstellung in der Reaktionskammer in die Ladestellung vorzugsweise ein ausschließlich vertikal betriebener Lift ist, so daß der über den Gaseinlaß der Reaktionskammer erzeugte laminare Luftstrom stets eine hinreichende Schutzhülle für den Waferträger ergibt, der damit seine Ladestellung exakt unterhalb der Reaktionskammer einnimmt.

Um auch im oberen Bereich des pyramidenstumpfförmigen Waferträgers mit Sicherheit laminare Bedingungen für den Schutzgasstrom zu schaffen, ist es vorteilhafterweise vorgesehen, auf dem oberen Plateau dieses Waferträgers einen strömungstechnisch günstig geformten Aufsatz vorzusehen. Gemäß einer vorteilhaften Ausgestaltung weist dieser Trägeraufsatz einen pyramidenstumpfförmigen Basisteil auf, dessen Mantelfläche nahtlos in die Mantelfläche des Waferträgers übergeht, während der obere Abschnitt des Aufsatzes, dem Gaseinlaß der Reaktionskammer gegenüberliegend, die Form eines Kugelsegments aufweist.

Ein derartig strömungstechnisch vorteilhaft ausgestalterer Trägeraufsatz unterstützt zusätzlich die gewünschte Strömungsführung in der Reaktionskammer im oberen Bereich zwischen deren Innenwandung und dem Waferträger, in dessen Arbeitsstellung beim epitaktischen Beschichten. In dieser Stellung wirkt der strömungstechnisch günstig ausgelegte Trägeraufsatz vorteilhaft zusammen mit einem erfindungsgemäß als Gasdiffusor ausgebildeten Gaseinlaß.

Neben einer günstigen Strömungsführung besteht ein weiterer Vorteil des Gasdiffusors darin, daß die Spül- und Reaktionsgase gleichmäßig verteilt auf die Oberfläche des Waferträgers geführt werden, so daß sämtliche auf dem Träger angebrachten Wafer gleichmäßig mit derselben Prozeßgasatmosphäre konfrontiert sind, was zu einer gleichmäßigen Beschichtung der Waferoberflächen vorteilhaft beiträgt.

Unter Berücksichtigung der glockenförmigen Reaktionskammer sowie des pyramidenstumpfförmigen Trägers ist der dem Träger gegenüberliegende Teil des Gasdiffusors kreisscheibenförmig ausgebildet. Die Kreisscheibe erstreckt sich im wesentlichen parallel zum oberen Plateau des pyramidenstumpfförmigen Trägers und weist radial verlaufende Gasaustrittsöffnungen auf, die am Umfang dieser Scheibe verteilt sind. Der scheibenförmige Teil des Gasdiffusors ist in seinem Umfangsbereich strömungsbegünstigend geformt und weist mit Vorteil einen konisch sich erweiternden unteren Randbereich auf, um die Strömung der am Diffusorumfang austretenden Gase turbulenzfrei an den Trägeraufsatz anzukoppeln. Zu diesem Zweck ist der Gasdiffusor, der koaxial zur gemeinsamen Längsachse des Trägers und der Reaktionskammer verläuft, parallel zu dieser Achse verstellbar. Durch die axiale Verstellbarkeit läßt sich der Diffusor problemlos in die strömungstechnisch optimale Lage gegenüber dem Träger und der Kammerinnenwandung positionieren.

Zu dem erfindungsgemäß beabsichtigten günstigen und insbesondere turbulenzfreien Strömungsprofil im oberen Teil der Reaktionskammer trägt auch mit Vorteil ein kreisförmiger Schild bei, der im wesentlichen den Durchmesser des Gaseinlaßhalses der Reaktionskammer aufweist und damit die Halsöffnung strömungsmäßig weitgehend verschließt. Zusätzlich ist der Gaseinlaßhals bekanntlich noch in seinem äußeren Endbereich mit einem Flansch verschlossen.

Weitere Maßnahmen zur erfindungsgemäßen Strömungsführung betreffen die Ausgestaltung der Kanten der Waferträger sowie die Ausgestaltung der Trägerbasis. Zu diesem Zweck ist es vorgesehen, die Längskanten des vielflächig ausgebildeten - im Epitaxiebetrieb drehangetriebenen - Waferträgers strömungsgünstig auszubilden, nämlich abzuflachen oder zu verrunden. Als weitere strömungstechnische Maßnahme ist der Träger basisseitig mit einem sich zum Gasauslaß im Kammerboden hin verjüngenden Sockel ausgerüstet, der gemäß einer vorteilhaften Ausgestaltung ebenfalls pyramidenstumpfförmig ausgebildet ist, wobei das größerflächige Plateau dieses Pyramidenstumpfes sich bündig an die Trägerunterseite anschließt. Ähnlich wie beim Trägerkörper sind sämtliche Kanten des Trägersockels abgeflacht oder vorzugsweise verrundet ausgebildet. Das untere Plateau des vorteilhafterweise aus Graphit ausgebildeten Sockels ist an den Drehantrieb des Waferträgers angeschlossen.

Von der Gasströmung innerhalb der Reaktionskammer mitgeführte, durch die erfindungsgemäß gewählte Strömungsführung jedoch von den Waferoberflächen ferngehaltene Partikel reichern sich im Trägersockelbereich an der Sockelwandung selbst sowie am Kammerboden an. Letzterer weist Öffnungen auf, über welche die Gase aus der Reaktionskammer abgeleitet werden. Um zu verhindern, daß diese im Sockelbereich angereicherten Teilchen - etwa bei einer Unterbrechung des Epitaxiebetriebes nach Auftreten einer Störung - auf die eventuell bereits teilweise beschichteten Waferoberflächen gelangen, werden erfindungsgemäß die im Bereich des Trägersockels angesammelten Partikel dort eingeschlossen, und zwar derart, daß die dort angesammelten Teilchen auch bei einem bestimmungsgemäßen Transport des Waferträgers in die Ladezone und nach neuem Beladen in die Reaktionskammer zurück weder in den Reinluftraum noch in den Ringraum zwischen in Arbeitsstellung befindlichem Träger und Reaktionskammerwandung gelangen können. Als Einrichtung zum Zurückhalten der Partikel im Trägersockelbereich ist ein Ringeinsatz vorgesehen, der vorzugsweise aus Quarz besteht, sich im wesentlichen über die gesamte Höhe des Sockels erstreckt und angrenzend an den Innenwandbereich der Reaktionskammer dicht am Kammerboden aufsitzt. Die am Kammerboden vorgesehenen Gasaustrittsöffnungen im Ringraum sind dabei zwischen der Innnenwandung des Ringeinsatzes und der Sockelaußenwandung angeordnet. Als zusätzliche Maßnahme zum Zurückhalten der Teilchen ist es erfindungsgemäß vorgesehen, unterhalb des Kammerbodens und an diesen anschließend eine Partikelfalle in Form eines ringsum weitgehend geschlossenen Ringraumes auszubilden, welcher den Ringraum zum Kammerinneren hin abschließt. Die im Sockelbereich angereicherten Partikel gelangen durch Saugwirkung durch die Austrittsöffnungen im Kammerboden in diesen als Partikelfalle wirkenden Ringkanal, da die in die Kammer eingeführten Gase über den Boden des Ringkanals abgezogen werden.

An den Ringkanal schließt sich die Hebebühne des Vertikallifts für den Waferträger an. In der Hebebühne ist vorteilhafterweise der Drehantrieb für den Träger untergebracht. Der Drehantrieb erstreckt sich durch den als Partikelfalle dienenden Ringkanal und greift an der Sockelunterseite des Trägers an.

Gemäß einer vorteilhaften Weiterbildung umfaßt die Hebebühne randseitig eine Einrichtung zur verkantungsfreien, dichten passgenauen Ankupplung einer Kammerbodenstruktur an einen mit der Kammerbasis verbundenen Dichtflansch. Zu diesem Zweck umfaßt die Kuppeleinrichtung vorteilhafterweise drei im Abstand von etwa 120 ° um die kreisrunde Kammerbodenstruktur und den Dichtflansch angeordnete Verspannorgane in Form von Kniehebeln. Diese ergreifen die Kammerbodenstruktur sobald der Vertikallift diese Anordnung in unmittelbare Nähe Kammerdichtflansches überführt hat, bewirken den restlichen Vertikalhub der Kammerbodenstruktur unter passgenauer Führung über Schrägflächen, die sowohl am Dichtflansch wie an der Kammerbodenstruktur ausgebildet sind, und verspannen die beiden miteinander zu verbindenden Teile in ihrer Endstellung.

Wie aus den bisherigen Ausführungen hervorgeht, wird die erfindungsgemäße Strömungsführung mit dem Ziel, die Waferobflächen frei von Fremdpartikeln zu halten, auch von der Gestalt des Waferträgers beeinflußt. Um nun im täglichen Einsatz der Epitaxieanlage sicherzustellen, daß immer der für die jeweilige Reaktionskammer bestimmungsgemäß vorgesehene, geeignete Waferträger verwendet wird, wird der Waferträger erfindungsgemäß entsprechend markiert, vorzugsweise derart, daß diese Markierung von einem Peripheriegerät eines Prozeßrechners lesbar ist. Dieser Prozeßrechner steuert und überwacht vorzugsweise sämtliche Funktionen der Epitaxieanlage. Die Trägerkennung dient als Qualitätssicherungsmaßnahme. Um letztere im praktischen Betrieb vorort weitgehend unüberwindbar zu machen, ist erfindungsgemäß die Trägerkennung kodiert, derart, daß sie von einer Dekodiereinrichtung während des Epitaxiebetriebes bzw. unmittelbar vor dem Einleiten der Epitaxie-Reaktionsgase, also bei bereits aufgeheiztem Waferträger entschlüsselbar ist. Vorteilhafterweise ist es daher vorgesehen, die Einleitung der Epitaxie-Reaktionsgase von der Erkennung eines bestimmungsgemäßen Waferträgers abhängig zu machen.

Gemäß einer vorteilhaften Ausgestaltung der Trägerkennung besteht diese aus unterschiedlich stark ausgebildeten Bereichen in der Trägerwandung, deren unterschiedliche Wärmeabsorbtion mit Hilfe eines Pyrometers abgetastet und an die Dekodiereinrichtung weitergeleitet wird.

Für den Fernsteuertrieb, vor allem für einen vom Prozeßrechner gesteuerten Betrieb der Epitaxieanlage ist erfindungsgemäß ein Manipulator zum Beladen des Waferträgers mit Wafern vorgesehen, der innerhalb der Ladezone in Nachbarschaft zur Beladestellung des Waferträgers angeordnet ist, und zwar derart, daS in seinem Wirkungsbereich auch ein Wafermagazin liegt, das als Vorratsbehälter für frische, unbeladene Wafer und zum Sammeln von in der Reaktionskammer beladenen Wafern dient. Um die erfindungsgemäß gelenkte Strömungsführung im Reinluftraum, in dessen Ladezone der Manipulator angeordnet und ferngesteuert tätig ist, nicht ungünstig zu beeinflussen, um also mit anderen Worten durch Bewegungen des Manipulators vor allem in unmittalbarer Nähe des Wafermagazins und des Waferträgers, in der Gasströmung mitgeführte Partikel nicht auf die zu beschichtende Waferoberfläche zu überführen, ist es erfindungsgemäß vorgesehen, die Bewegung des Manipulators an die Strömung der umgebenden Gase anzupassen. Dabei ist eine Beschränkung der Bewegungsfreiheit des Manipulators mit Rücksicht auf eine ungestörte Vertikalströmung der Reinluft und der Laminarströmung des Schutzgases im Bereich der Ladezone vorgesehen, und zwar auf im wesentlichen vertikale Bewegungen des Manipulators. Diese Einschränkung der Manipulator-Bewegungsfreiheit kann vorteilhaft unterstützt werden durch eine Steuerung der Manipuliergeschwindigkeiten. Um durch Abrieb am Manipulator selbst erzeugte Partikel aus der Gasströmung fernzuhalten, ist bevorzugt als flankierende Maßnahme vorgesehen, den Manipulator in eine flexible Staubschutzhülle einzuschliessen.

Als Manipulator im Reinraum eignet sich jeder herkömmliche Typ. Mit besonderem Vorteil gelangt jedoch ein vom Prozeßrechner steuerbarer Roboterarm zum Einsatz. Ein derartiger Manipulator oder Roboterarm weist vorteilhafterweise ein Greiforgan mit zwei Fingern auf, die im wesentlichen längs einer gemeinsamen Achse verstellbar und gemeinsam um den Waferrand drehbar ausgebildet sind. Gemäß einer vorteilhaften Weiterbildung dieses Manipulators ist das Greiforgan zur Erfassung einer Markierung am Waferrand, vor allem des geraden Kantenabschnitts am Wafer mit einem optischen Detektor ausgerüstet. Dieser wirkt mit der Fingersteuerung derart zusammen, daß die Wafer immmer am kreisbogenförmigen Waferrand erfaßt werden. Ein Vorteil des optischen Detektors besteht darin, daß die Wafer immer gleichmäßig ausgerichtet, beispielsweise mit dem geraden Kantenabschnitt nach oben weisend, in die Waferausbuchtungen am Waferträger einsetzbar sind. Dadurch wird erreicht, daß jederzeit nach dem Beladen des Wafers bei dessen Weiterverarbeitung verifiziert werden kann, in welcher Orientierung die Waferoberflächen innerhalb der Reaktionskammer mit dem Prozeßgas beströmt worden sind.

Zur Gewährleistung eines reibungslosen Be- und Entladens der Trägerausbuchtungen mit den Wafern mittels des Zweifinger-Greiforgans sind die Trägerausbuchtungen im Randbereich jeweils mit zwei einander diagonal gegenübergelegenen Ausnehmungen versehen. Diese sind derart dimensioniert, daß sie die Finger des Manipulatorgreiforgans beim Untergreifen der Wafer aufnehmen. Vorteilhafterweise weisen die Finger im Greifbereich V-förmige Einkerbungen auf, deren Öffnungswinkel ein sicheres Ergreifen der Wafer am Waferrand gewährleistet.

Eine weitere vorteilhafte Ausführungsform des Manipulators sieht ein weiteres Greiforgan vor, das einen Saugnapf umfaßt, mit welchem im Magazin abgelegte Wafer auf der rückseitigen Fläche sicher erfaßbar sind.

Bei herkömmlichen pyramidenstumpfförmigen Waferträgern weisen die Ausbuchtungen zur Aufnahme der Wafer eine von der Bestückungsfläche ausgehende zylinderförmige Ausnehmung auf, an die sich nach innen hin ein Ausbuchtungsteil in Form eines Kugelschalensegments anschließt. Der zylinderförmige Ausbuchtungsabschnitt dient einer ausreichenden Halterung der Wafer innerhalb der Ausbuchtungen und hat eine Tiefe, die etwa der Waferdicke entspricht. Der kugelschalenförmige Ausbuchtungsabschnitt trägt dem Temperaturgradienten im Bereich der Trägerwandung bei aufgeheiztem Träger Rechnung. Nachteilig an dieser Auslegung der Ausbuchtungen im Waferträger ist die stark unterschiedliche Materialdicke der Ausbuchtungen, insbesondere im Randbereich. Erfindungsgemäß wird dieser Nachteil dadurch behoben, daß die Kugelschalensegmentform der Ausbuchtungen im wesentlichen kontinuierlich in die Waferträgeraußenfläche, also ohne Ausbildung eines Halterandes für die Wafer, übergeht. Als Stütze für die in diese Ausbuchtungen eingesetzten Wafer dienen vorteilhafterweise zwei voneinander beabstandete, auf der Horizontalen liegenden Stützpunkte, die im unteren Bereich jeder Waferausbuchtung vorgesehen sind. An Stelle der Zweipunktstütze, kann auch ein horizontal verlaufender Steg vorgesehen sein. Überraschenderweise werden durch diese Maßnahme die sonst auftretenden Beschichtungsunsymmetrien an den Waferrändern verringert.

Einen erheblichen Beitrag zu einer möglichst partikelfreien Strömungsführung leistet der erfindungsgemäß ausgebildete Gasmischer, der im wesentlichen aus einer Gashauptleitung besteht sowie aus einer Vielzahl von registerartig mit der Hauptleitung verbundenen Zweigleitungen, über welche die Vektor-, Reaktions-, Schutz-, und Spülgase zur Hauptleitung überführt werden, deren eines Ende an den Gaseinlaß der Reaktionskammer angeschlossen ist. Die Einleitung der Gase in die Zweigleitungen dieses Gasmischers erfolgt geordnet nach der technischen Reinheit sowie Agressivität der verwendeten Gase derart, daß die unreineren und agressiveren Gase mit Priorität in die am nächsten zum Gaseinlaß der Reaktionskammer angeordneten Zweigleitungen eingespeist werden. Dadurch wird erreicht, daß möglichst kurze Leitungsstrecken innerhalb des Gasmischers von relativ unreinen Gasen durchströmt werden, wobei ebenfalls relativ geringe Abschnitte des Leitungssystems von agressiven Gasen angegriffen werden können. Insgesamt wird hierdurch ein Herauslösen von Partikeln aufgrund agressiver Gaseigenschaften innerhalb des Gasmischers auf ein Minimum beschränkt.

Als sauberstes und am wenigsten agressives Gas wird dementsprechend mit Vorteil das für den Epitaxieprozeß benötigte Vektorgas am der Reaktionskammer abgewandten Ende der Gashauptleitung in den Gasmischer eingespeist. Der üblicherweise als Spülgas in Epitaxieanlagen verwendete Stickstoff wird vorteilhafterweise, - obwohl wenig agressiv und relativ sauber-, deshalb am kammerseitigen Ende der Gashauptleitung in den Gasmischer eingespeist, da erfahrungsgemäß mit dem Medium Stickstoff im täglichen Laborbetrieb relativ sorglos umgegangen wird. So besteht durchaus die Gefahr, daß beispielsweise statt hochreinem Stickstoff normaler Stickstoff an den Gasmischer angeschlossen wird. Bei einem Anschluß des Stickstoffs an eine vom Gasmischerauslaß entferntere Zweigleitung würde dies zu einer gravierenden Kontamination der Gasmischerleitungen führen.

Zur rechnergesteuerten und rechnererfaßten Messung der Wafer- und Waferträgertemperatur in der Reaktionskammer dient vorteilhafterweise ein Pyrometer mit einem an eine Glasfaserleitung angschlossenen Meßkopf. Dieser ist in relativ kurzer Entfernung, etwa 20 cm, von der Oberfläche des Waferträgers außerhalb der Induktionsheizung und parallel zur Längsachse des Waferträgers verschiebbar positioniert. Durch die Verwendung eines Lichtleiters kann der temperaturempfindliche Teil des Pyrometers in hinreichendem Abstand zur Induktionsheizung angeordnet werden. Vorteilhafterweise wird ein Pyrometer verwendet, daß auf zwei Wellenlängen der Wärmestrahlung des Waferträgers abgestimmt ist, wobei zumindest die Strahlung mit der einen Wellenlänge die dielektrische Wandung der Reaktionskammer im wesentlichen ohne Intensitätsverlust auch dann durchdringt, wenn diese Wandungen innenseitig bis zu einer bestimmten Schichtdicke mit Reaktionsprodukten des Epitaxieprozesses beschichtet ist. Damit wird in jedem Betriebszustand eine Wärmekontrolle des Epitaxiereaktors gewährleistet.

Mit großem wirtschaftlichen Vorteil wird innerhalb der Epitaxieanlage mindestens eine weitere Reaktionskammer betrieben, die anschlußmäßig sowie strömungs- und bedientechnisch wie die bereits beschriebene Reaktionskammer und der Waferträger ausgelegt sind. Damit gewährleistet die Epitaxieanlage ein unabhängiges Be- und Entladen der Waferträger mit Hilfe des fern- oder prozeßgesteuerten Manipulators. Bei einem derartigen Mehrkammersystem ist der Gasmischer vorteilhafterweise in sich sowie bezüglich seiner Anordnung und Anschlüsse zu den Reaktionskammern symmetrisch ausgelegt, um stets für sämliche Reaktionskammern dieselben Prozeßbedingungen von Seiten der Prozeßgase zu schaffen.

Ursprünglich wurden die Induktionsheizungen in Epitaxieanlagen von Hochfrequenzgeneratoren gespeist, die in einem Frequenzbereich von über 100 000 Hz und Spannungen von mehreren 1000 V betrieben worden sind. Da die Leistungsausbeute eines derartigen HF-Generators relativ gering ist, wurden Versuche unternommen, Generatoren mit einem Frequenzbereich von weniger als 10 000 Hz zur Speisung der Induktionsheizung zu verwenden. Trotz besserer Leistungsausbeute haben sich diese Niederfrequenzgeneratoren jedoch nicht bewährt, da deren Frequenzen für das menschliche Ohr hörbar sind und die von diesen Generatoren ausgehende Lärmbelästigung für das Betriebspersonal zumindest im längeren Betrieb unerträglich ist. Aus diesem Grunde umfaßt die erfindungsgemäße Epitaxieanlage einen Generator zur Speisung der Induktionsheizung bzw. der Induktionsheizungen, in einem Frequenzbereich, der nicht zu Lärmbelästigungen für das Betriebspersonal führt und sich im Vergleich zu bisher bekannten Generatoren durch einen verbesserten Wirkungsgrad auszeichnet. Der Arbeitsbereich dieses Generators liegt vorteilhafterweise zwischen 15 kHz und 100 KHz, und vor allem zwischen 16 kHz und 25 kHz.

Die Rechnersteuerung der erfindungsgemäßen Epitaxieanlage gewährleistet im Dialog mit dem Bedienpersonal einen automatisierten Betrieb des Epitaxieprozesses und -wie bereits ausgeführt- der Beladung der Waferträger. Der Dialog zwischen Rechner und Benutzer erfolgt dabei vorteilhafterweise über einen Farbbildschirm, auf dem zur besseren Übersichtlichkeit jeweils nur die aktuellen Prozesse und Anlagenzustände getrennt für jede Reaktionskammer dargestellt sind.

Eine besonders vorteilhafte Ausgestaltung der Rechnersteuerung sieht eine Berücksichtigung eventuell auftretender Fehlfunktionen beim Ablauf des Epitaxieprozesses vor, wobei Fehlfunktionen ihrer Bedeutung für den Epitaxieprozeß und den Schutz des Bedienpersonals entsprechend gewichtet sind. Dabei werden in Übereinstimmung mit der vorgenommenen Gewichtung abgestufte Maßnahmen im weiteren Prozeßablauf rechnergesteuert ausgelöst. Das Spektrum der vorgesehenen Maßnahmen umfaßt als Extremmaßnahme den Notausstieg aus dem laufenden Prozeß, beispielsweise wenn Gaslecks ermittelt werden. Hierbei stellt insbesondere das Austreten von Wasserstoff aus der Anlage, oder der Ausfall der Stromversorgung der Anlage einige Gefahr für das Bedienpersonal dar. In diesen Fällen wird umgehend Spülgas, vor allem Stickstoff über den Gasmischer in die Reaktionskammer eingeleitet.

Wird dem rechnerunterstützten Überwachungssystem eine Fehlfunktion der Anlage angezeigt, nachdem bereits zumindest ein Teil der bestimmungsgemäßen Beschichtung auf den Wafer aufgebracht worden ist, so werden Maßnahmen getroffen, um die Beschichtung durch Einleiten eines geeigneten Gases in die Reaktionskammer zu retten.

Wenn sich die ermittelte Fehlfunktion als im laufenden Epitaxieprozeß reparabel herausstellt, so ist es vorgesehen, den Epitaxieprozeß im laufenden Stadium anzuhalten oder um einen Schritt zurückzusteuern, wobei gleich nach Beenden der Fehlfunktion, also nach Ausführen der Reparatur, der Epitaxieprozeß an der Abbruchstelle fortgesetzt wird.

Die Erfindung soll nunmehr anhand der Zeichnung näher erläutert werden; in dieser zeigt:
- Fig. 1:: Eine schematische Darstellung der erfindungsgemäßen Epitaxieanlage;
- Fig. 2:: Eine schematische Darstellung des in der Anlage von Fig. 1 verwendeten Gasmischers;
- Fig. 3:: Eine teilweise geschnittene Darstellung des im Gaseinlaßhals der Reaktionskammer von Fig. 1 angeordneten Gasdiffusors;
- Fig. 4:: Eine Schnittdarstellung des Sockelbereichs des Waferträgers von Fig. 1;
- Fig. 5:: Eine perspektivische Darstellung einer Ladezone sowie eines Manipulators der Epitaxieanlage von Fig. 2;
- Fig. 6:: Eine schematische Ansicht einer Ausbuchtung zur Aufnahme eines Wafers auf dem Waferträger;
- Fig. 7:: Eine Schnittansicht des Randbereichs der mit einem Wafer belegten Ausbuchtung von Fig. 6;
- Fig. 8:: Einen Horizontalschnitt durch den oberen Bereich des Waferträgers und
- Fig. 9:: Eine Kupplungseinrichtung für die Bodenstruktur der Reaktionskammer von Fig. 1.

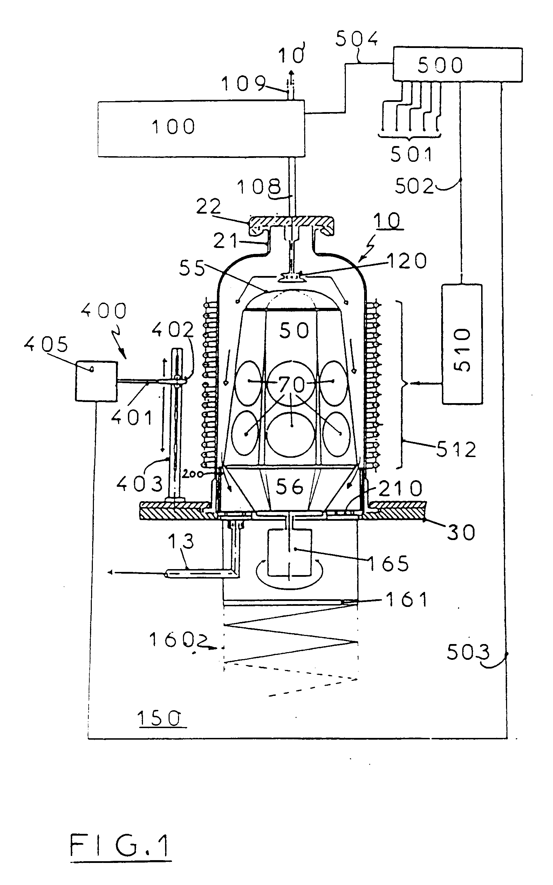

Fig.1 zeigt die prinzipielle Anordnung der Komponenten einer erfindungsgemäßen Epitaxieanlage, die mindestens eine Reaktionskammer 10 umfaßt. Dieser Reaktionskammer 10 werden die für die epitaxiale Beschichtung von Wafern 70 benötigten Reaktionsgase über einen Gasmischer 100 zugeführt, der mit der Reaktionskammer 10 über eine Leitung 108 verbunden ist. Über eine weitere Verbindungsleitung 109 ist der Gasmischer 100 im gezeigten Ausführungsbeispiel an eine weitere, nicht dargestellte Reaktionskammer 10' der Epitaxieanlage angeschlossen. Letztere ist im wesentlichen so aufgebaut und wird so gesteuert wie die in Fig.1 dargestellte Reaktionskammer 10.

Über den Gasmischer 100 werden den Reaktionskammern 10, 10' neben den Reaktionsgasen auch weitere Gase, wie Vektor-, Spül- und Schutzgase über die jeweiligen Leitungen 108 und 109 zugeführt. Die Verbindungsleitung 108 mündet in einen Gasdiffusor 120, der in den Abschlußflansch 22 eines Gaseinlaßhalses 21 der Reaktionskammer 10 eingesetzt ist. Die vom Gasmischer 100 gelieferten Gase strömen aus dem Gasdiffusor 120 in einen Ringraum zwischen einen Suszeptor oder Waferträger 50 und die Innenwandung der Reaktionskammer 10.

Der Waferträger 50 weist gemäß dem dargestellten Ausführungsbeispiel die Gestalt eines Pyramidenstumpfes auf, dessen Seitenflächen mit einer Vielzahl von im wesentlichen kreisrunden Ausnehmungen zur Aufnahme von Wafern 70 ausgebildet sind. Der pyramidenstumpfförmige Waferaufnehmer 50 ist koaxial zur Kammerlängsachse ausgerichtet und mittels eines Antriebs 165 um die Achse drehantreibbar.

Zur strömungsbegünstigenden, vor allem turbulenzfreien Führung der Gase in der Reaktionskammer 10 ist das obere, verjüngte Ende des pyramidenstumpfförmigen Waferträgers 50 mit einem Aufsatz 55 und an der breitauslaufenden Basis mit einem Sockel 56 versehen. Der Sockel 56 ist ebenfalls pyramidenstumpfförmig gestaltet und hat im wesentlichen die gleiche Querschnittsform wie der Waferträger 50. Sein verjüngtes Ende weist jedoch zur Kammerbasis. Die Mantelfläche seines anderen Endes geht glatt in die Mantelfläche des Basisbereiches des pyramidenstumpfförmigen Waferträgers 50 über.

Die Basisfläche des Trägeraufsatzes 55 und die Querschnittsfläche des verjüngten Endes des Waferträgers 50 sind im wesentlichen gleich geformt und gleichgroß. Die Mantelfläche im Basisbereich des Trägeraufsatzes 55 geht nahtlos in die Mantelfläche des Waferträgers 50 über. Die Basisfläche des Aufsatzes 55 geht in eine im wesentlichen sphärische und damit besonders strömungsgünstige nach oben gewölbte Fläche über.

Während der Körper des Waferträgers 50 zur besonders günstigen Wärmeabsorbtion aus Graphit besteht, ist der Sockel 56 vorteilhafterweise aus einem isolierenden Material, beispielsweise Quarz gefertigt. Hierdurch werden im Basisbereich der Reaktionskammer 10 angeordnete wärmeempfindliche Teile, beispielsweise die Antriebseinrichtung 165, vor der hohen Betriebstemperatur des Waferträgers 50 geschützt.

Wie im nachfolgenden noch näher auszuführen ist, sind im Bereich des Trägersockels 56 Einrichtungen, nämlich ein Ringeinsatz 200 und eine Partikelfalle 210 zum Sammeln von beim Epitaxieprozeß entstehenden sowie von den Gasen mitgeführten Partikeln vorgesehen.

Der Beheizung der auf dem Waferträger 50 angeordneten Wafer 70 für die Erzeugung der notwendigen Reaktionstemperatur dient eine Induktionsheizung. Diese besteht im wesentlichen aus einem Hochfrequenzgenerator 510 und einer vom HF-Generator gespeisten Heizspirale 512. Die Heizungsspirale 512 umgibt die vorzugsweise aus Quarz bestehenden Wandung der Reaktionskammer 10 unter Ausbildung eines Ringraumes im wesentlichen zylindrisch. In den Ringraum zwischen der Reaktionskammerwandung 10 und der Heizspirale 512 wird zur Kühlung der Kammerwandung ein Fluid, vor allem Luft eingeführt.

Im Bereich der Heizspirale 512 ist ein ebenfalls im wesentlichen zylinderförmiger Reflektor ausgebildet, vor allem in Form von Metallstreifen, wie grundsätzlich aus der DE 35 25 870 A1 bekannt.

Der Hochfrequenzgenerator 510 arbeitet bei einer Betriebsfrequenz, die über der Wahrnehmungsschwelle des menschlichen Gehörs, also im wesentlichen über 16 kHz liegt, vor allem bei 20 kHz.

Die Wafertemperatur bzw. die Temperatur des Waferträgers 50 wird mit Hilfe eines Pyrometers 400 überwacht. Dessen temperaturempfindliche Teile sind in einem Gehäuse 405 fern von der Induktionsheizung 512 untergebracht. Das Pyrometer weist einen Tastkopf 402 auf, der in der Umgebung der Heizspirale 512 angeordnet und über einen Lichtleiter 401, vor allem eine Lichtfaser, an die Auswerteoptik innerhalb des Gehäuses 405 angeschlossen ist. Der Tastkopf 402 ist auf einem Stativ 403 höhenverstellbar angeordnet, um den drehangetriebenen und wärmestrahlenden Waferkörper 50 sowie die darauf angeordneten Wafer an beliebigen Stellen temperaturmäßig erfassen zu können. Parallel zur Verstellstrecke des Tastkopfes 402 sind im Reflektor der Induktionsheizspule 512 Öffnungen vorgesehen, durch welche Wärmestrahlung aus dem Inneren der Reaktionskammer im wesentlichen ungeschwächt zum Tastkopf 402 des Pyrometers gelangt.

Weiterhin weist die Epitaxieanlage eine elektronische Kontrolleinheit 500 mit einem Prozeßrechner auf. Diese elektronische Kontrolleinheit 500 dient zur Steuerung der gesamten Epitaxieanlage. So werden beispielsweise die mit Hilfe des Pyrometers 400 erfaßten Wärmewerte über eine Leitung 503 zur elektronischen Kontrolleinheit 500 übertragen. Über eine weitere Leitung 502 ist der HF- Generator 510 durch die elektronische Kontrolleinheit 500 steuerbar. Weitere Parameter des Epitaxieprozesses, beispielsweise der Gasdruck innerhalb der Reaktionskammer 10, werden über Sensoren erfaßt, die über Leitungen 501 an die Kontrolleinheit 500 angeschlossen sind. Über eine weitere Leitung 504 wird auch der Gasmischer 100 mittels der Kontrolleinheit 500 gesteuert.

Mittels eines Vertikalliftes 160 ist der Waferträger 50 mit samt der Bodenstruktur der Reaktionskammer 10, der Teilchensammeleinrichtungen 200 und 210, der Trägerantriebseinrichtung 165, der Gasauslaßleitung 13 und weiteren in Fig.1 nicht dargestellten Zu- und Ableitungen für Kühlfluide aus der Arbeitsstellung in eine Ladezone 150 überführbar. Die Ladezone ist direkt unterhalb der in ihrer Stellung verbleibenden Reaktionskammer 10 in einem Reinluftraum der Epitaxieanlage ausgebildet.

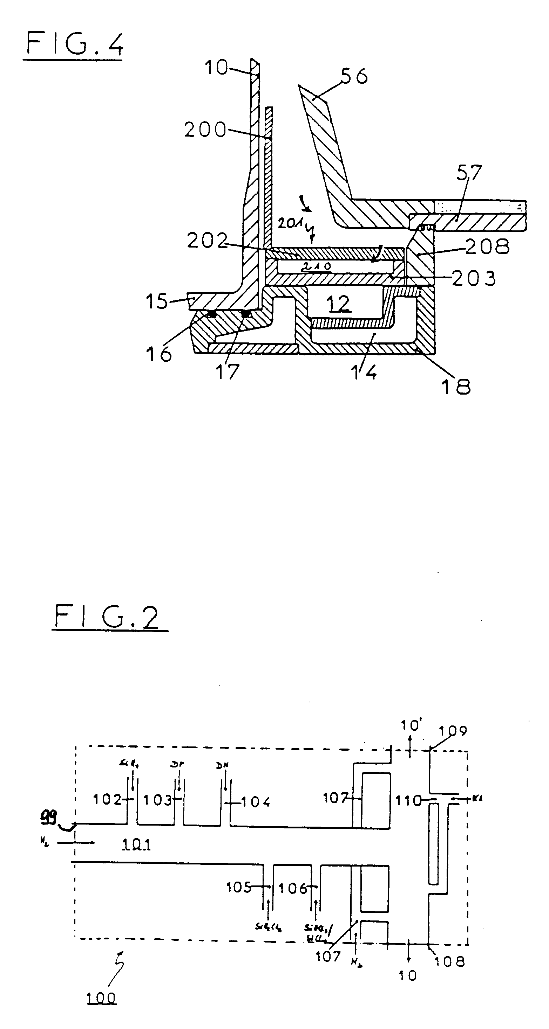

Der in der Epitaxieanlage von Fig.1 verwendete Gasmischer ist in Fig.2 schematisch dargestellt.

Der Gasmischer 100 bzw. die ihm zugeführten Gase stellen unter anderem eine Quelle von beim Epitaxieprozeß unerwünschten Fremdkörpern in Form kleiner und kleinster Teilchen dar. Obwohl für den Epitaxieprozeß nur reinste Gase verwendet werden, sind jedoch vor allem die Gase, die Chlorverbindungen enthalten, ausgesprochen aggresive Gase. Diese können die Edelstahl-Rohrleitungen des Gasmischers angreifen. Die dabei aus den Rohrwandungen herausgelösten Verunreinigungen sind durchaus in der Lage, den Epitaxieprozeß, vor allem das geordnete Aufwachsen von Atomen auf die Waferoberflächen zu stören. Es muß deshalb dafür gesorgt werden, die Anzahl der durch aggresslve Gase innerhalb des Rohrleitungssystems des Gasmischers 100 erzeugten Teilchen möglichst gering zu halten. Aus diesem Grunde ist der in Fig. 2 schematisch dargestellte Gasmischer 100 aus einer im wesentlichen geradlinigen Hauptleitung 101 aufgebaut, in welche registerartig eine Vielzahl von Zweigleitungen 102 bis 107 einmündet. Über diese Zweigleitungen werden die unterschiedlichen Gase zur Vermischung miteinander und zum Weiterleiten an die Reaktionskammern 10 und 10' über die Verbindungsleitungen 108 und 109 eingeleitet. Die Zuleitung der einzelnen Gassorten erfolgt dabei gestaffelt nach ihrer jeweiligen Aggressivität, derart, daß die aggressivsten Gase nahe der Mischerausgänge, an den die Verbindungsleitungen 108 und 109 angeschlossen sind, erfolgt. Dadurch wird erreicht, daß die aggressiveren Gase eine wesentlich kürzere Rohrstrecke innerhalb des Gasmischers 100 durchlaufen, als die weniger aggressiven und gar die inerten Gase.

In diesem Sinne wird am Einlaß 99 des Hauptrohrs 101 das für den Epitaxieprozeß benötigte Vektorgas, vor allem Wasserstoff eingeleitet. Diesem werden auf seinem Strömungsweg durch das Hauptrohr 101 der Reihe nach Reaktionsgase mit zunehmender Aggressivität beigemischt. So wird beispielsweise über eine auf den Einlaß 99 folgende Zweigleitung 102 gasförmiges SiH₄ zugeführt, gefolgt von Dotierungsmittel vom p-Typ, wie beispielsweise B₂H₆ in gasförmigem Zustand. Stromabwärts folgt die Zweigleitung 104, über welche Dotierungsmittel vom n-Typ zum Vektorgas in der Hauptleitung 101 hinzugemischt wird. Dabei handelt es sich vornehmlich um PH₃, AsH₃, jeweils in Gasform sowie um das flüssige SbCl₅ In der Rangfolge zunehmender Aggressivität folgt über die Zweigleitung 105 die Zuleitung einer weiteren gasförmigen Siliciumquelle, nämlich SiH₂Cl₂, gefolgt von flüssigem SiHCl₃ oder dem flüssigen SiCl₄, die alternativ über die Zweigleitung 106 zugeführt werden.

Am auslaßseitigen Ende ist die Hauptleitung 101 T-förmig verzweigt und mündet schließlich in die Verbindungsleitungen 108 bzw. 109 zu den beiden Reaktionskammern 10 und 10'. In diesem Bereich der Hauptleitung, also so nahe wie möglich am Auslaßbereich des Gasmischers 100 wird das extrem aggressive HCl-Gas in die Hauptleitung 101 über eine zweiarmige Zweigleitung 110 eingeleitet, die gleichweit entfernt in die beiden T-förmigen Armabschnitte der Hauptleitung 101 mündet. In gleicher Weise wird in den T-förmigen Abschnitt der Hauptleitung 101 über eine zweiteilige Zweigleitung 107 Spülgas in Form von Stickstoff-Gas in die Hauptleitung 101 eingeführt. Der Stickstoff wird aus praktischen Gründen erst im Auslaßbereich der Hauptleitung 101 in den Gasmischer 100 eingespeist. Stickstoff ist zwar gegenüber dem Rohrmaterial im wesentlichen inert, wird aber im Laborbereich in verschiedenen Reinheitsgraden verwendet. Durch obige Maßnahme soll verhindert werden, daß versehentlich in weniger reiner Form in den Gasmischer 100 eingeleitetes Stickstoffgas, diesen auf weite Strecken verunreinigt.

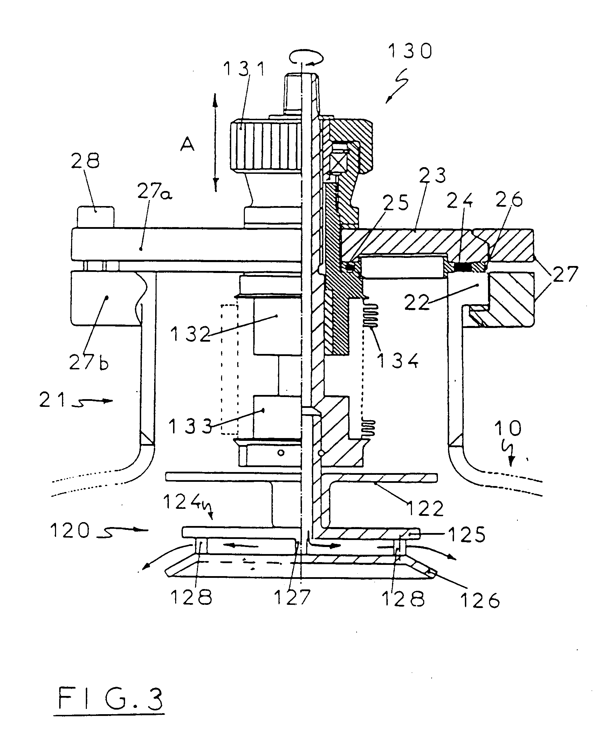

Fig. 3 zeigt, teilweise in geschnittener Darstellung, den Gaseinlaßhals 21 der glockenförmigen Reaktionskammer 10 von Fig. 1 in vergrößerter Darstellung. An seinem äußeren Ende ist der Gaseinlaßhals 21 mit einem Flansch 22 versehen und mittels einer Platte 23 verschlossen. Für einen dichten und dauerhaften Sitz der Verschlußplatte 23 auf der Oberseite des Halsflansches 22 sorgt eine Spanneinrichtung 27. Diese umfaßt zwei Ringe 27a und 27b, von denen der eine Ring 27a die konisch abgeschrägte Oberkante der Verschlußplatte 23 und der andere Ring 27b die Unterkante des Halsflansches 22 umgreift. Miteinander verbunden und gegenseitig verspannt sind die beiden Ringe 27a und 27b in bekannter Weise mittels Schrauben, von denen in Fig. 3 lediglich die Schraube 28 dargestellt ist.

In die Verschlußplatte 23 ist ein Stellmechanismus 130 zur axialen Verstellung des Gasdiffusors 120 dicht eingesetzt. Der Mechanismus 130 umfaßt ein außerhalb der Reaktionskammer 10 angeordnetes Drehstellglied 131, das entweder manuell oder beispielsweise mittels eines Elektromotors antreibbar ist. Innerhalb des Gaseinlaßhalses 21 der Reaktionskammer 10 umfaßt der Mechanismus 130 ein ortsfest mit der Verschlußplatte 23 verbundenes Führungsglied 132 und ein in dieses kolbenartig eingreifendes in axialer Richtung (Richtung des Pfeiles A) verstellbares Glied 133. Um zu verhindern, daß Schmiermittel oder bei der Verstellbewegung des Gliedes 133 erzeugter Abrieb in die Reaktionskammer 10 gelangt, ist zwischen den beiden Gliedern 132, 133 ein Balg 134, beispielsweise aus Tombakblech, dicht eingesetzt.

Um zu gewährleisten, daß die Stellachse des Verstellmechanismus 130 mit der Längsachse der glockenförmigen Reaktionskammer 10 fluchtet, ist zwischen der Verschlußplatte 23 und dem Halsflansch 22 ein Zentrierring 26 eingesetzt. Der Zentrierring 26 dient zusätzlich zur Führung eines O-Rings 24, der eine dichte Verbindung der Verschlußplatte 23 mit dem Halsflansch 22 sicherstellt, sowie eines weiteren, innenliegenden O-Rings 25, der den Verstellmechanismus 130 gegenüber der Verschlußplatte 23 abdichtet.

Der am kammerinnenseitigen Ende des Verstellmechanismus 130 an dessen Glied 133 angeschlossene Diffusor 120 umfaßt zwei plattenförmige Gebilde 122 und 124. Direkt an das Glied 133 schließt sich ein runder, scheibenförmiger Teil 122 an, mit dem der eigentliche Reaktionsraum der Kammer 10 vom Gaseinlaßhals 21 strömungsmäßig entkoppelt ist. Daran schließt sich, dem Trägeraufsatz 55 gegenüberliegend, der eigentliche Diffusor in Form eines scheibenförmigen Gebildes 124 an. Dieses Gebilde 124 besteht aus einem dem scheibenförmigen Teil 122 gegenübergelegenen Deckenteil 125 und einem mit Abstand zu letzterem angeordneten Bodenteil 126. Boden- und Deckenteil 125, 126 sind miteinander durch einen Zentralstift 127 und eine Vielzahl von am Umfang der beiden Teile angebrachte Stifte 128 miteinander verbunden.

Die Reaktions-, Spül- und Schutzgase werden an einer nicht dargestellten Einlaßöffnung im oberen Bereich des Verstellmechanismus in einen zentral durch diesen verlaufenden Kanal eingespeist, treten zwischen Deckenteil 125 und Bodenteil 126 des Diffusors 120 in den Innenraum der Reaktionskammer 10 aus und folgen dabei einem durch die Pfeile im Bereich des Gasdiffusors 120 dargestellten Strömungsprofil. Dieses Profil weist im Bereich des Gasdiffusors 120 sowie zwischen diesem und dem Trägeraufsatz 55 im wesentlichen Glockengestalt auf, wobei der glockenförmige Strömungsverlauf begünstigt wird durch den konisch abfallenden Rand des Bodenteils 126 des Diffusors 120. Als Material für den Diffusor 120 wird Quarz bevorzugt.

Die Höhenverstellbarkeit des Diffusors 120 ermöglicht eine günstige Anpassung des Strömungsprofils an den für die Gase zur Verfügung stehenden Strömungsraum.

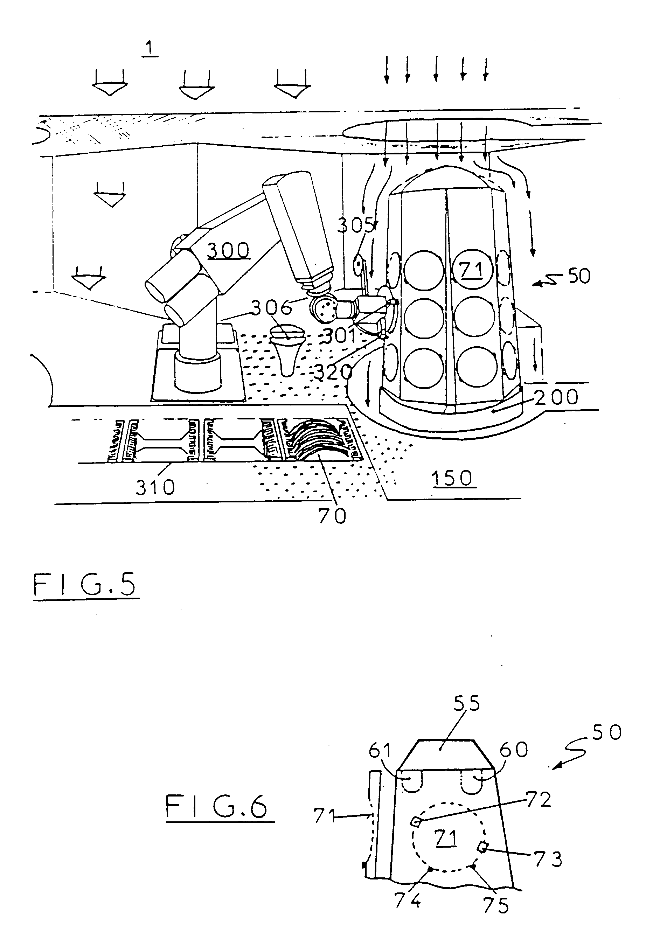

Fig. 4 zeigt einen Ausschnitt der Bodenstruktur der Reaktionskammer 10. Letztere weist am unteren Ende einen Flanschansatz 15 auf. Die profilierte Bodenstruktur der Reaktionskammer 10 befindet sich in der Fig. 4 in Anlage gegen die Unterseite des Flanschansatzes 15, wobei eine dichte Verbindung durch zwei O-Ringe 16 und 17 gewährleistet ist. Die Stellung der Bodenstruktur von Fig. 4 entspricht der Arbeitsstellung des Waferträgers 50 innerhalb der Reaktionskammer 10. Zur Überführung des Waferträgers 50 in die Ladezone, sind sämtliche in Fig. 4 innerhalb der Reaktionskammer 10 dargestellten Teile mittels des Liftes 160 (Fig. 1) in die Ladezone überführbar.

Zwischen dem Trägersockel 56 und der Innenwandung der Reaktionskammer 10 ist ein Ringeinsatz 200 aus Quarz im wesentlichen unmittelbar anschließend an die Kammerwandung angeordnet. Dieser Ringeinsatz 200 sitzt auf dem oberen Kantenbereich einer ringförmigen Kammer 201 dicht auf, die dem Kammergasauslaß 12 vorgeschaltet ist. In der Ringkammer 201 sollen im Bereich zwischen dem Ringeinsatz 200 und dem Sockel 56 angesammelte Fremdstoffteilchen angesammelt und zurückgehalten werden. Zu diesem Zweck sind sowohl die ringförmige Deckenplatte 202 wie der im Querschnitt U-Profil aufweisende Bodenteil 203 der Kammer 201 mit Ein- bzw. Auslaßöffnungen für die Gas- und Teilchenströme versehen. Dabei sind die Einlaßöffnungen, wie durch die die Strömung in Fig. 4 verdeutlichenden Pfeile dargestellt, vorzugsweise unterhalb des Sockelbodens angeordnet.

Zur wirksamen Zurückhaltung der Teilchen innerhalb des Ringraums 210 kann zwischen Boden- und Deckelteil der Ringkammer 201 vorteilhafterweise eine perforierte Zwischendecke eingezogen sein, wobei die Perforierung in dieser Zwischendecke radial versetzt zu den Einlaßöffnungen im Deckelteil 202 angeordnet ist.

Zur Kühlung der heißen Austrittsgase ist unterhalb des ringförmigen Auslaßkanals 12 ein weiterer Ringkanal 14 ausgebildet, der ein kühlendes Fluid, vorzugsweise Wasser, führt.

Als Kühlmaßnahme zwischen der Ringkammer 201 und dem in Fig. 4 nicht dargestellten Trägerantrieb, der an die Bodenplatte 57 des Trägersockels 56 angeschlossen ist, ist ein ringförmiges Hitzeschild 208 angeordnet.

In Fig. 5 ist der in die Ladezone 150 überführte Waferträger 50 dargestellt, der mit Hilfe eines rechnergesteuerten Manipulators 300 in Form eines Roboterarms mit Wafern 70 beladbar oder von diesen entladbar ist.

Der Roboterarm 300 befindet sich im Reinluftraum 1 zwischen den Ladezonen von mehreren, beispielsweise zwei Waferträgern 50. Im Fall von zwei zu beladenden Waferträgern befindet sich der zweite Waferträger in nicht sichtbarer Stellung links neben dem Manipulator 300 von Fig. 5.

In Fig. 5 ist die Reinluftströmung durch die breiten Pfeile und die erfindungsgemäß vorgesehene Schutzgasströmung, durch die schmalen Pfeile dargestellt. Die Schutzgasströmung umschließt den Waferträger 50 bei dessen Überführung in die Ladezone 150 und zurück in seine Arbeitsstellung innerhalb der Reaktionskammer 10. Dabei wird deutlich, daß beide Strömungen parallel zueinander und vertikal von oben nach unten geführt sind.

Des Roboterarm 300 ist gemäß Fig. 5 mit seiner Greifeinrichtung schwenkbar so ausgelegt, daß er sowohl Zugriff hat zu dem im Vordergrund von Fig. 5 angeordneten Wafermagazin 310 wie zu einer vertikalen Reihe der Ausbuchtungen 71. Durch entsprechende Drehung des Trägers 50 mittels der dafür vorgesehenen Antriebseinrichtung können die vertikalen Reihen der Ausbuchtungen 71 schrittweise nacheinander in eine günstige Be- bzw Entladeposition zum Roboterarm 300 überführt werden. Die Greifeinrichtung besteht im wesentlichen aus zwei unabhängigen Greiforganen, nämlich einem Fingerpaar 301 und einem Saugnapf 305. Von den zwei Fingern 301 ist in Fig. 5 nur einer sichtbar.

Auf etwa halbem Wege zwischen dem ortsfesten Sockel des Roboterarms 300 und der Ladezone 150 ist eine Rampe 306 angeordnet, auf welcher die Wafer 70 jeweils abgesetzt werden, bevor sie in den Ausbuchtungen 71 des Trägers 50 oder in den dafür vorgesehenen Ausnehmungen des Wafermagazins 310 plaziert werden. Die Rampe dient dem Roboterarm 300 als Relaisstation, in welcher er den Wafer zwischenlagert, um ihn mit dem jeweils geeigneten Greiforgan in die jeweilige Endstellung entweder am Waferträger 50 oder im Wafermagazin 310 zu überführen.

Zur Überführung aus dem Wafermagazin 310 auf die Rampe 306 oder umgekehrt, dient das Greiforgan in Form des Saugnapfes 305. Mit diesem wird der Wafer 70 auf seiner der Beschichtungsseite abgewandten Rückseite ergriffen und in das Magazin zurückgestellt oder aus diesem entnommen und mit der zu beschichtenden Fläche nach oben auf der Rampe 306 abgelegt.

Der auf der Rampe 306 positionierte noch unbeschichtete Wafer 70 wird von dem zweiten, die beiden Finger 301 umfassenden Greiforgan randseitig erfaßt und in die vorbestimmte Ausbuchtung 71 im Waferträger 50 überführt. Umgekehrt wird der beschichtete Wafer 70 aus der entsprechenden Ausbuchtung 71 von dem Zweifingerorgan 301 frontal entnommen und mit der nichtbeschichteten Rückseite auf der Rampe 306 abgelegt.

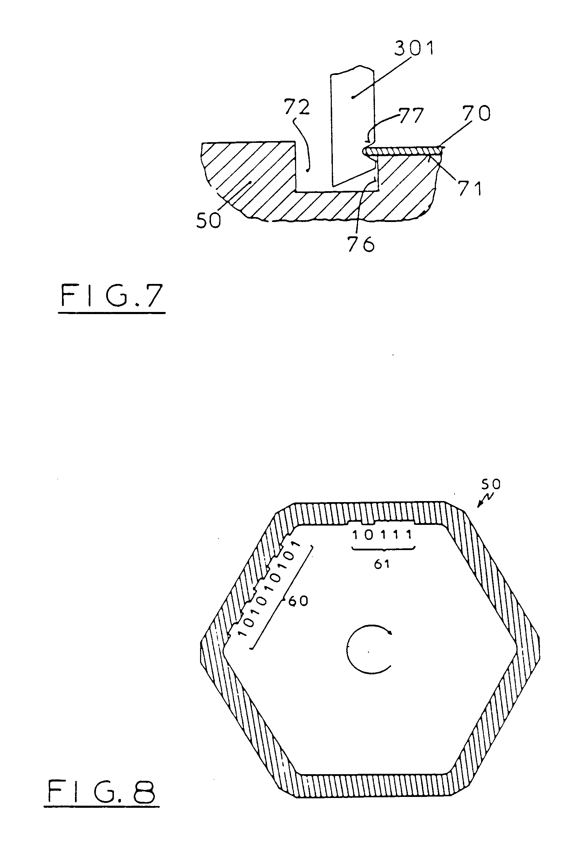

Wie den Detaildarstellungen gemäß Fig. 6 und 7 zu entnehmen, sind die Ausbuchtungen 71 auf der Manteloberfläche des Waferträgers 50 im wesentlich sphärisch gekrümmt ausgebildet und weisen im Randbereich, einander diagonal gegenüberliegend zwei Ausnehmungen 72 und 73 auf. Einen Teilschnitt durch die Ausbuchtung 71 im Bereich einer der Ausnehmungen 72 ist in Fig. 7 dargestellt. Dabei ist ersichtlich, daß der Abstand der Innenränder 76 der Ausnehmungen 72 und 73 geringfügig kleiner ist als der Waferdurchmesser, so daß der Wafer im Bereich der Ausnehmungen 72 und 73 in diese vorsteht. Im Bereich der Fingerspitzen ist jeweils ein keilförmiger Einschnitt 77 ausgebildet, der so bemessen ist, daß die beiden Finger 301 und 302 den Waferrand im Bereich der Ausnehmungen 72 und 73 untergreifen kann, ohne an die Innenkanten der Ausnehmungen 72 und 73 anzustoßen. Dadurch wird erreicht, daß mit den beiden einander diagonal gegenübergelegenen Greiferfingern der Wafer randseitig erfaßt und in die Ausbuchtungen 71 eingesetzt oder aus diesen entnommen werden kann.

Wafer sind im wesentlichen kreisrund ausgebildet und weisen zur Markierung einen geradlinigen Kantenabschnitt auf. Um nun das Einsetzen eines Wafers 70 in die dafür vorgesehene Ausbuchtung 71 mit Hilfe der dort randseitig vorgesehenen Ausnehmungen 72 und 73 sowie der beiden Greiferfinger 301 und 302 bewerkstelligen zu können, ist es erforderlich, den Wafer 70 an zwei Punkten zu ergreifen, die jeweils am Kreisrand des Wafers angeordnet sind. Zur Erkennung des Waferrandes weist das mit den beiden Fingern versehene Greiforgan einen optischen Detektor 320 auf. Das durch den optischen Detektor 320 gesteuerte, randseitige Ergreifen des Wafers 70 durch die beiden Greiferfinger erfolgt vorzugsweise so, daß sich der Detektor 320 am geradlinigen Kantenabschnitt des Wafers orientiert und dann die beiden Finger 301 und 302 immer in eine vorbestimmten, stets gleichbleibende Position zum geradliniegen Kantenabschnitt bringt. Dadurch ist gewährleistet, daß die Reaktionsgase während der Waferbeschichtung stets in derstelben vorbestimmten Richtung bezüglich der Waferoberfläche strömen.

Wie aus der Schnittansicht der Ausbuchtung 71 im linken Teil der Fig. 6 ersichtlich, erstreckt sich die sphärische Kontur dieser Ausbuchtung bis an die Manteloberfläche des Waferträgers 50, in welche die Ausbuchtung im wesentlichen stetig übergeht. Dadurch wird eine Vergleichmässigung der Wärmeverteilung innerhalb der Ausbuchtung 71 bei aufgeheiztem Waferträger 50 und Wafer 70 erreicht. Um zu verhindern, daß der Wafer 70 aus einer derart ausgebildeten Ausbuchtung 71 herausrutscht, sind am unteren Randbereich der Ausbuchtung mit Abstand zueinander zwei Stützpunkte 74 und 75 ausgebildet.

Bei dem punktförmigen Ergreifen des Waferrandes an zwei Stellen durch die Finger 301, 302 des Manipulators 300 ist zu beachten, daß diese beiden Waferrandstellen nicht mit einer kristallographischen Achse zusammenfallen. Belastungen, die entlang einer derartigen Kristallachse verlaufen, führen leicht zu Rißbildungen und damit zu einer Zerstörung des Wafers 30. Aus diesem Grund ist die Verbindungsachse der beiden Ausnehmungen 72, 73 so anzuordnen, daß sie in Abhängigkeit vom jeweiligen Wafertyp und dessen gewünschter Positionierung in der Ausbuchtung 71 nicht mit einer kristallinen Vorzugsrichtung zusammenfallen. - Gewöhnlich wird der Wafer 70 so in der Ausnehmung 71 positioniert, daß sein geradliniger Kantenabschnitt an oberster Stelle liegt.

Fig. 8 verdeutlicht das erfindungsgemäß angewandte Prinzip zur Erkennung eines Waferträgers 50 unmittelbar vor Beginn des Epitaxieprozesses oder während desselben. Diesem Prinzip liegt eine unterschiedlich starke Emission von Wärmestrahlung als Funktion der Wanddicke eines wärmeabstrahlenden Körpers zugrunde. Demgemäß ist an einer vorbestimmten Stelle des Waferträgers 50, vorzugsweise im Bereich der Trägeroberkante eine Kennung 60 vorgesehen. Diese Trägerkennung 60 umfaßt beabstandete Wandabschnitte unterschiedlicher Stärke, die bevorzugt auf derselben Höhenlinie des Waferträgers angeordnet sind, etwa nach Art einer Strich- oder Balkenkodierung. Im dargestellten Ausführungsbeispiel der Trägerkennung 60 besteht diese aus linear angeordneten Schwächungsstellen am Innenwandbereich des Trägers 50, denen eine logische 1 bei der Auswertung im nachgeschalteten Prozeßrechner nach Erfassung durch das Pyrometer 400 (Fig.1) zugeordnet ist. Beim vorliegenden Ausführungsbeispiel besteht die Kennung also aus einer Aufeinanderfolge von Wandschwächungen, die jeweils von einer ungeschwächten Wandstelle unterbrochen sind, entsprechend der Aufeinanderfolge einer logischen 1 und einer logischen 0.

Anstelle von Schwächungsstellen eignen sich zur Trägerkennung ebenso an der Trägerwandung vorgesehene Materialverstärkungen.

Zusätzlich zu der die Information über die Trägerart enthaltenden Trägerkennung 60 bedarf es in Nachbarschaft zu dieser Kennung einer Information, die den Detektor zur Auswertung der Trägerkennung initialisiert. Diese besteht beim Ausführungsbeispiel der Kennung von Fig. 8 in einer zusätzliche Schwächungsstellen umfassenden Wandkennung 61, die an einem Wandabschnitt des Waferträgers 50 angebracht ist, der in Drehrichtung des Trägers 50, die hier dem Uhrzeigersinn entspricht, der eigentlichen Trägerkennung 60 vorgeschaltet ist.

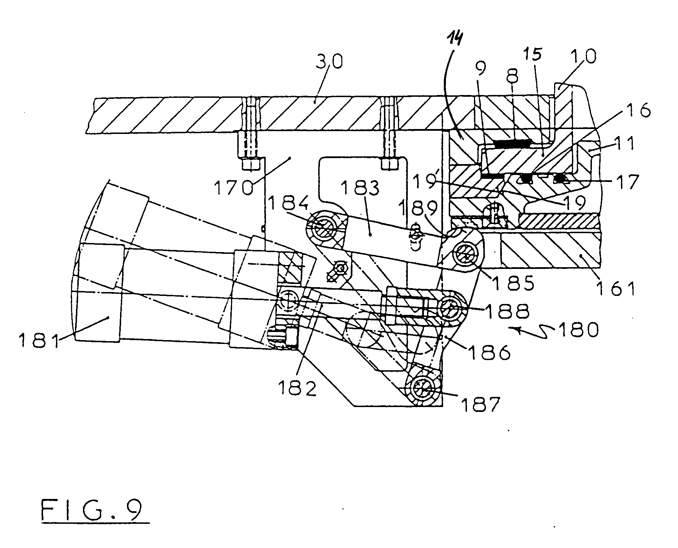

Fig. 9 zeigt eine Kuppeleinrichtung 180 die zur verkantungsfreien Ankupplung der Bodenstruktur 11 der Reaktionskammer an den Basisflansch 15 dieser Kammer ausgebildet ist.

Wie bereits beschrieben, wird die Bodenstruktur 11 zusammen mit dem auf dieser Struktur positionierten Waferträger 50 mittels eines Vertikallifts 160 mit einer Hebebühne 161 von der Ladezone 150 in eine angehobene Stellung überführt, in welcher letztlich die Bodenstruktur 11 an die Verbindungsfläche des Basisflansches 15 der Reaktionskammer 10 dichtend angeschlossen werden soll. Für eine dichte Verbindung der Bodenstruktur 11 mit dem Flansch 15 dienen O-Ringe 16 und 17, die in Kreisnuten der Bodenstruktur 11 sitzen. Der Basis-Flansch 15 ist in eine ringförmigen Ausnehmung einer Stützplatte 30 eingesetzt. Dabei sind zwischen den Kontaktflächen des Flansches 15 und der Innenwandung der ringförmigen Ausnehmung Elastomerringe 8 und 9 eingesetzt. Diese Elastomerringe 8 und 9 schützen das druckempfindliche Quarzmaterial, aus dem der Flansch 15 ebenso besteht wie die restliche Wandung der Reaktionskammer 10, vor einer Beschädigung.

Zur dichtenden Ankupplung der Bodenstruktur 11 an die untere Verbindungsfläche des Flansches 15 wird diese Bodenstruktur mit Hilfe des Vertikallifts 160 bis in den Bereich des Flansches 15 angehoben. Dabei wird die Hubbewegung der Hebebühne 161 des Lifts gestoppt, sobald die der Flanschunterseite gegenüberliegende, mit den O-Ringen 16 und 17 bestückte Verbindungsfläche der Bodenstruktur 11 auf die Höhe der Unterkante einer Schrägfläche 19' angehoben ist, die unterhalb der Aussparung zur Aufnahme des Flansches 15 in der Stützplatte 30 ausgebildet ist. Die Schrägfläche 19' ist ringförmig als Kegelsegment ausgebildet, das sich mit Richtung auf den Flansch 15 hin verjüngt. Zur Paßaufnahme der Bodenstruktur 11 durch die Schrägfläche 19' der Stützplatte 30 ist der sich an die Verbindungsfläche mit den O-Ringen 16 und 17 anschließende Randbereich der Bodenstruktur 11 ebenfalls als ringförmige Schrägfläche ausgebildet. Mit dieser Schrägfläche 19 wird die Bodenstruktur 11 gleitend entlang der Schrägfläche 19' der Stützplatte 30 geführt, sobald die Kuppeleinrichtung 180 die Bodenstruktur 11 von unten ergreift und anhebt.

Die Kuppeleinrichtung 180 besteht aus mehreren Hebelmechanismen, die im Bereich des kreisrunden Kammerflansches 15 umfangsmäßig voneinander beabstandet an einem Stützprofil 170 angelenkt sind, das an der Unterseite der Platte 30 befestigt ist. Im dargestellten Ausführungsbeispiel umfaßt die Kuppeleinrichtung 180 drei winkelmäßig um 120° voneinander beabstandete Hebelmechanismen.

Jeder Hebelmechanismus umfaßt zwei Hebel 183 und 186. Der erste Hebel 183 ist mit einem Ende schwenkbar an einem Zapfen 184 gelagert, der im Stützprofil 170 eingesetzt ist. Das andere Ende des ersten Hebels 183 ist über einen Zapfen 185 mit dem zweiten Hebel 186 verbunden, dessen anderes Ende an einem im Stützprofil 170 befestigten Zapfen 187 gelagert ist. Betätigt werden die beiden Hebel durch den Kolben 182 eines Betätigungsmechanismus 181, der am Stützprofil 170 gelagert ist. Etwa mittig zwischen den Lagerzapfen 185 und 187 ist am zweiten Hebel 186 ein weiterer Zapfen 188 vorgesehen, an dem der Kolben 182 schwenkbar gelagert ist.

In Fig. 9 ist die kuppelnde Endstellung der beiden Hebel 183 und 186 mit durchgezogenen Linien und die Entkupplungsstellung dieser Hebel mittels strichpunktierten Linien dargestellt. In der Entkupplungsstellung befindet sich der Kolben 182 in seiner in den Betätigungsmechanismus 181 zurückgezogenen Stellung, wobei dieser Mechanismus gleichzeitig so verschwenkt ist, daß die beiden Hebel 183 und 186 den Hubbereich der Schwenkbühne 161 freigeben. Sobald die Hebebühne 161 ihre hochgefahrene Stellung einnimmt, werden die Hebel 183 und 186 durch den Betätigungsmechanismus 181 in ihre Kupplungsstellung überführt. In dieser untergreift eine im Bereich des Verbindungszapfens 185 am ersten Hebel 183 ausgebildete Nockenfläche 189 einen komplementär zu dieser Nockenfläche ausgebildeten Flächenbereich an der Unterseite der Bodenstruktur 11, wobei der zweite Hebel 186 im wesentlichen die Stützlast trägt. Die Nockenfläche 189 sowie die mit ihr zusammenwirkende an der Bodenstruktur 11 ausgebildete Fläche wirken mit der Anordnung der beiden Hebel 183 und 186 derart zusammen, daß die Bodenstruktur 11 mit zunehmendem Hub des Betätigungskolbens 182 unter Führung durch die Schrägflächen 19 und 19' exakt vertikal nach oben in eine dichtende Stellung mit dem Flansch 15 gefahren wird.

## Patentansprüche

1. Epitaxieanlage zum Aufbringen von halbleitenden Schichten auf halbleitende Wafer (70) mit wenigstens einer Reaktionskammer (10) zur Aufnahme eines pyramidenstumpfförmigen, drehbaren Trägers (50) für die Halterung der Wafer, wobei die Reaktionskammer mit mindestens einem Gaseinlass und einem Gasauslass für die Zu-oder Abführung von Vektor-, Reaktions-, Spül-, Reinluft- und/oder Schutz-Gasen versehen ist und dem Gaseinlass ein Gasmischer (100) zum Mischen der Gase vorgeschaltet ist, dadurch gekennzeichnet, dass die Epitaxieanlage ein Paar von Reaktionskammern (10,10') aufweist, die anschlussmässig, strömungs- und bedienungstechnisch gleich ausgelegt sind und für ein unabhängiges Laden der Waferträger (50) sowie für einen unabhängigen Epitaxiebetrieb beider Reaktionskammern eingerichtet sind, dass der Gasmischer (100) mit einer, über eine symmetrisch ausgebildete Verzweigung an die Gaseinlässe der Reaktionskammern (10,10') angeschlossenen Gashauptleitung (101) und einer Mehrzahl von registerartig an aufeinanderfolgenden Stellen in die Hauptleitung (101) mündenden Zweigleitungen (102-107,110) zur Zuführung der Reaktions- und Spülgase versehen ist, wobei diese Gase bei Betrieb der Anlage ihrer technischen Reinheit sowie Aggressivität entsprechend derart in den registerartig aufeinanderfolgende Zweigleitungen eingespeist werden, dass die unreineren und aggressiveren Gase mit Priorität in die am nächsten zum Gasauslass (108,109) des Gasmischers (100) angeordneten Zweigleitungen eingespeist werden, und dass mindestens die zwei in Strömungsrichtung gesehen zuletzt in die Gashauptleitung einfliessenden Zweigleitungen (107,110) je über ein Paar von symmetrisch in die Hauptleitung mündende Kanäle an dieser angeschlossen sind.

2. Epitaxieanlage nach Anspruch 1, dadurch gekennzeichnet, dass in Betrieb das Vektorgas an dem dem Auslass (108,109) des Gasmischers (100) gegenüberliegenden Ende (99) der Hauptleitung (101) eingespeist wird.

3. Epitaxieanlage nach Anspruch 1 oder 2, dadurch gekennzeichnet, dass in Betrieb das Spülgas durch Leitung (107) unmittelbar im Bereich des Auslasses (108,109) des Gasmischers (100) in die Hauptleitung (101) eingespeist wird.

4. Epitaxieanlage nach einem der vorangehenden Ansprüche, dadurch gekennzeichnet, dass der Gaseinlass aus einem koaxial zur Längsachse des Waferträgers (50) ausgerichteten und entlang dieser Längsachse einstellbaren Gasdiffusor (120) besteht, derart, dass das Strömungsprofil der aus dem Gasdiffusor (120) in die Reaktionskammer (10) eintretenden Gase im wesentlichen turbulenzfrei in das sich zwischen der Kammerinnenwandung und der Waferträgerkontur einstellende Strömungsprofil übergeht.

5. Epitaxieanlage nach Anspruch 4, mit einer im wesentlichen glockenförmigen Reaktionskammer (10), dadurch gekennzeichnet, dass der Gasdiffusor (120) im wesentlichen in Form eines Rundstempels ausgebildet ist, sich mit dem Stempelschaft in den Gaseinlasshals (21) der Reaktionskammer (10) erstreckt, mit seinem kreisscheibenförmigen Basisteil dem oberen Waferträgerende gegenüberliegt und darin radial verteilte Gasaustrittsöffnungen aufweist.

6. Epitaxieanlage nach Anspruch 5, dadurch gekennzeichnet, dass der Gasdiffusor (120) im Bereich eines Stempelschaftes eine Strömungsleitplatte (124) aufweist, mit der der Gaseinlasshals im wesentlichen gegen die Gasströmung in der Reaktionskammer (10) verschliessbar ist.

7. Epitaxieanlage nach einem der vorangehenden Ansprüche, dadurch gekennzeichnet, dass die Waferträger-Längsachse und der Gaseinlass in der Decke (20) der Reaktionskammer (10) koaxial zur Kammerlängsachse verlaufen.

8. Epitaxieanlage nach einem der vorangehenden Ansprüche, gekennzeichnet durch einen Ringeinsatz (200), der an der Bodenstruktur (11) der Reaktionskammer (10) aufsitzt, an deren Innenwandbereich dicht angrenzt und den Waferträger (50) im Sockelbereich so umgibt, dass am Kammerboden (11) vorgesehene Gasaustrittsöffnungen (12) im Ringraum zwischen der Innenwandung des Ringeinsatzes (200) und der Trägersockelaussenwandung zu liegen kommen.

9. Epitaxieanlage nach Anspruch 8, dadurch gekennzeichnet, dass die Gasaustrittsöffnungen (12) am Kammerboden (11) in einen als Partikelfalle ausgebildeten Raum (210) münden.

10. Epitaxieanlage nach Anspruch 9, dadurch gekennzeichnet,dass der Partikelfallenraum aus einem einen Waferträger-Drehantrieb umschliessenden Ringkanal (21) besteht, der auf der Oberseite von Kammerboden (11) mit den Austrittsöffnungen und an der Unterseite von einem ebenfalls mit Oeffnungen (216) versehenen Boden (215) begrenzt ist, wobei die Bodenöffnungen (216) an Gasauslassleitungen angeschlossen sind.

11. Epitaxieanlage nach einem der vorstehenden Ansprüche mit einer Einrichtung (160) zum Transportieren des Waferträgers (50) zwischen einer ausserhalb der Reaktionskammer (10) befindlichen Ladezone (150) und einer Arbeitsstellung in der Reaktionskammer (10), einer Einrichtung (300) zum Be- und Entladen des Waferträgers (50) mit Wafern (70) und einem diese Einrichtungen (160,300) aufnehmenden Reinluftraum (1), dadurch gekennzeichnet, dass die Hilfsmittel auch zur Führung von Reinluft- und Schutzgasen durch den Reinluftraum (1) ausgelegt sind.

12. Epitaxieanlage nach Anspruch 11, dadurch gekennzeichnet, dass die Ueberführungseinrichtung ein Lift (160) für eine Vertikalbewegung des Waferträgers (50) zusammen mit der Bodenstruktur (11) der Reaktionskammer (10) und der Ladezone (150) unterhalb der Reaktionskammer (10) ist.

13. Epitaxieanlage nach einem der Ansprüche 11 oder 12, gekennzeichnet durch Hilfsmittel zur Sicherstellung eines den Waferträger (50) beim Ueberführen zwischen der Ladezone (150) und der Arbeitsstellung innerhalb der Reaktionskammer (10) und/oder beim Verbleib in der Ladezone (150) umgebenden im wesentlichen laminaren Schutzgasstromes ausgebildet und angeordnet sind.

14. Epitaxieanlage nach Anspruch 13, dadurch gekennzeichnet, dass der laminare Schutzgasstrom von in die Reaktionskammer (10) aus dem Gasmischer (100) eingeführten Spülgas gebildet ist, die Reaktionskammer (10) vom Gaseinlass in der Decke (20) der Reaktionskammer (10) bis zur offenen Kammerbasis durchströmt und den Waferträger (50) im wesentlichen laminar strömend einhüllt.

15. Epitaxieanlage nach einem der Ansprüche 11 oder folgende, dadurch gekennzeichnet, dass die Reinluftströmung im Reinluftraum (1) zumindest im Bereich der Ladezone (150) als ein ebenfalls im wesentlichen laminar und gleichgerichtet zum den Waferträger (50) und diesen umhüllenden Schutzgasstrom geführt ist.

16. Epitaxieanlage nach einem der Ansprüche 12 oder folgende, gekennzeichnet durch eine im Bodenbereich der Reaktionskammer (10) vorgesehene Einrichtung zur passgenauen Ankupplung der Kammerbodenstruktur (11) an einen an der Kammerbasis ausgebildeten Dichtflansch (15), die wenigstens drei im wesentlichen gleichmässig beabstandet um die Kammerbasis verteilte Kniehebelmechanismen (180) umfasst, welche die vom Lift (160) an den Dichtflansch (15) an der Kammerbasis herangefahrenen Kammerbodenstruktur randseitig von unten erfassen und mittels aus Dichtflansch (15) wie aus der Kammerbodenstruktur (11) ausgebildeten Schrägführungsflächen (19) in eine abdichtende Passstellung überführen und in dieser verspannen.

17. Epitaxieanlage nach einem der vorangehenden Ansprüche, wobei der Waferträger (50) Ausbuchtungen (71) zur Aufnahme der Wafer (70) aufweist, die im wesentlichen eine zum Waferträgerinnern hin gekrümmte Kugelschalensegmentform aufweisen, mit welcher dem Temperaturgradienten im Bereich der Trägerwandung bei aufgeheiztem Träger Rechnung getragen wird, dadurch gekennzeichnet, dass diese Kugelschalensegmentform der Ausbuchtungen (71) im wesentlichen kontinuierlich in die Waferträgeraussenfläche übergeht.

18. Epitaxieanlage nach Anspruch 17, gekennzeichnet durch eine im unteren Randbereich der Ausbuchtungen (71) vorgesehene, von der Waferträgeraussenfläche leicht vorspringende Waferstütze.

19. Epitaxieanlage nach Anspruch 18, dadurch gekennzeichnet, dass die Waferstütze aus zwei voneinander beabstandeten, auf der Horizontalen liegenden Stützpunkten (74,75) besteht.

20. Epitaxieanlagenach einem der Ansprüche 11-19 , gekennzeichnet durch einen im Bereich der Ladezone (150) angeordneten und vertikal von oben nach unten mit Reinluft umströmten, fernsteuerbaren Manipulator (300) zum Beladen des Waferträgers (50) mit Wafern (70) aus einem im Reinluftraum (1) angeordneten Wafermagazin (310) sowie zum Entladen behandelter Wafer (70) vom Waferträger (50) in das Wafermagazin (310), wobei die Bewegungsfreineit des Manipulators (300) mit Rücksicht auf eine ungestörte Vertikalströmung der Reinluft sowie Laminarströmung des Schutzgases zumindest im Bereich des sich in der Ladezone (150) befindenden Waferträgers (50) auf im wesentlichen vertikale Bewegungen beschränkt ist.

21. Epitaxieanlage nach Anspruch 20, dadurch gekennzeichnet, dass der Manipulator (300) von einer flexiblen Staubschutzhülle umgeben ist.

22. Epitaxieanlage nach Anspruch 20 oder 21, dadurch gekennzeichnet, dass der Manipulator ein vom Prozessrechner steuerbarer Roboterarm (300) ist.

23. Epitaxieanlage nach einem der Ansprüche 20-22 folgende, dadurch gekennzeichnet, dass der Manipulator (300) zum Erfassen des Waferrandes ein Greiforgan mit zwei Fingern (301, 302) umfasst, die im wesentlichen längs einer gemeinsamen Achse verstellbar und gemeinsam um den Waferrand drehbar sind, und dass das Greiforgan (301,302) zur Erfassung eines Markierung am Waferrand, vor allem des geraden Kantenabschnitts am Wafer (70) mit einem optischen Detektor (320) ausgerüstet ist, wobei der Wafer (70) von den beiden Fingern (301,302) in Uebereinstimmung mit der vom Detektor (320) optisch erfassten Randmarke am kreisbogenförmigen Waferrandabschnitt erfasst wird.

24. Epitaxieanlage nach einem der Ansprüche 20-23, dadurch gekennzeichnet, daß der Manipulator (300) ein weiteres Greiforgan (305) mit einem Saugnapf aufweist, mit welchem im Magazin abgelegte Wafer (70) auf der rückseitigen Waferfläche erfaßbar sind.

25. Epitaxieanlage nach einem der Ansprüche 20-24, wobei am Waferträger im wesentlichen kreisrunde Ausbuchtungen zur Aufnahme der Wafer ausgebildet sind, dadurch gekennzeichnet, dass die Ausbuchtungen (71) im Randbereich (2) zwei einander diagonal gegenüber gelegene Ausnehmungen (72, 73) aufweisen, die derart dimensioniert sind, dass die Finger (301, 302) des Manipulatorgreiforgans die in den Ausbuchtungen (71) eingesetzten bzw. einzusetzenden Wafer (70) randseitig untergreifen können.

26. Epitaxieanlage nach einem der vorangehenden Ansprüche, mit einem pyramidenstumpfförmigen Waferträger (50), dadurch gekennzeichnet, dass der Waferträger (50) an seinem oberen und/oder seinem basisseitigen Ende einen eine laminare Strömung begünstigenden Aufsatz (55) bzw. einen eine laminare Strömung begünstigenden Sockel (56) aufweist.

27. Epitaxieranlage nach einem der vorangehenden Ansprüche, mit einem Waferträger (50), dessen Querschnitt die Form eines Vielecks hat, dadurch gekennzeichnet, dass die Kanten des Waferträgers (50) abgestumpft oder verrundet sind.

28. Epitaxieanlage nach Anspruch 1, mit einem Rechner zur Steuerung des Epitaxieprozesses, dadurch gekennzeichnet, dass der Rechner eingerichtet ist, um nach dem Auftreten einer Fehlfunktion der Anlage den weiteren Prozessablauf in Abhängigkeit der aufgetretenen Störung zu steuern.

## Claims

1. Epitaxial facility for the application of semiconducting layers onto semiconductor wafers (70), with at least one reaction chamber (10) to accommodate a rotatable support (50) shaped as a truncated pyramid for holding the wafers, the chamber being provided with at least one gas inlet and one gas outlet for the admission and discharge of supporting, reaction and scavenging gases, as well as pure air and/or a protective gas, where a gas mixing device (100) for mixing the gases is provided upstream of the gas inelt, characterized in that the epitaxial facility comprises a pair of reaction chambers (10, 10') which are set up identically as far as connections, flows, and operating techniques are concerned, the two chambers being arranged so their wafer support (50) can be loaded independently, and that the epitaxial processes in them can be performed independently, where the gas mixing device (100) comprises a main gas line (101) hooked up to the gas inlets of the reaction chambers (10, 10') through symmetric junctions, and several branch lines (102-107, 110) opening sequentially into successive points of the main line (101) for the in-feed of reaction and scavenging gases, these gases being fed, during the junctioning of the facility, according to their technical purity and corrosiveness into branch lines which succeed each other register-fashion in such a way that the less pure and more aggressive gases are fed preferentially into the branch lines located closest to the gas outlet (108, 109) of the gas mixer (100), and that at least the two branch lines (107, 110) which enter most downstream into the main line are each connected to the latter through a pair of ducts which enter it symmetrically.

2. Epitaxial facility according to claim 1, characterized in that during its functioning the supporting gas is fed in at the extremity (99) of the main line (101) opposite to the outlet (108, 109) of the gas mixer (100).

3. Epitaxial facility according to claim 1 or 2, characterized in that during its functioning the scavenging gas is fed into the main line (101) through a line (107) in the immediate proximity of the outlet (108, 109) of the gas mixer (100).

4. Epitaxial facility according to any preceding claim, characterized in that the gas inlet consists of a gas diffuser (120) coaxial to the longitudinal axis of the support (50) and adjustable along said axis, in such a way that the flow profile of the gas entering the reaction chamber (10) from the gas diffuser (120) transforms itself essentially without turbulences into the flow profile existing between the inner surface of the chamber and the contour of the support.

5. Epitaxial facility according to claim 4, with an essentially bell-shaped reaction chamber (10), characterized in that the gas diffuser (120) essentially has the shape of a circular die, the shank of which extends into the gas inlet neck (21) of the reaction chamber (10) and the disk shaped base portion of which faces the upper end of the wafer support and comprises radially distributed gas outlets.

6. Epitaxial facility according to claim 5, characterized in that the gas diffuser comprises in the area of its die shank a flow guide plate (124), with which the gas inlet neck can be substantially closed against the flow of gas in the reaction chamber (10).

7. Epitaxial facility according to any preceding claim, characterized in that the longitudinal axis of the wafer support and the gas inlet at the ceiling (20) of the reaction chamber (10) are coaxial to the longitudinal axis of that chamber.

8. Epitaxial facility according to any preceding claim, characterized by a ring insert (200) which rests on the floor structure (11) of the reaction chamber (10), the inner wall of which it hugs closely, and surrounds the wafer support (50) in the area of its pedestal in such a way that the gas outlet openings (12) provided on the chamber floor (11) are situated in the annular space between the inner wall of the ring insert (200) and the outer wall of the support pedestal.

9. Epitaxial facility according to claim 8, characterized in that the gas outlets (12) on the chamber floor (22) lead into a space (210) designed as a particle trap.

10. Epitaxial facility according to claim 9, characterized in that the particle trap space consists in an annular channel (21) enclosing a rotary drive of the wafer support, said annular channel being limited at the top by the chamber floor structure (11) with the outlet holes, and at the bottom by a floor (215) likewise provided with holes (216), these holes being connected to gas outlet ducts.

11. An epitaxial facility according to any preceding claim, with a device (160) for transporting the wafer support (50) between a charging zone (150) located outside of the reaction chamber (10) and a working position inside the reaction chamber (10), a device (300) for charging the wafer support (50) with wafers (70) and removing them from it, and a clean-air space (1) accommodating these devices (160, 300), characterized in that the auxiliary means are set up also for conducting the clean-air and protective gases through the clean-air space (1).

12. An epitaxial facility according to claim 11, characterized in that the transfer device is a lift (160) for vertical movement of the wafer support (50) together with the floor structure (11) of the reaction chamber (10) and the charging zone (150) beneath the reaction chamber (10).

13. Epitaxial facility according to claim 11 or 12, characterized by auxiliary means designed and set up to ensure a substantially laminar stream of protective gas surrounding the wafer support (50) when it is transferred between the charging zone (150) and the working position within the reaction chamber (10) and/or while it stays in the charging zone (150).

14. An epitaxial facility according to claim 13, characterized in that the laminar protective gas stream is constituted by scavenging gas which is introduced into the reaction chamber (10) from the gas mixer (100), flows through the reaction chamber (10) from the gas inlet in the ceiling (20) of the reaction chamber (10) to the open chamber base, and surrounds the wafer support (50) in a substantially laminar stream.

15. An epitaxial facility according to claim 11 or the following ones, characterized in that the flow of pure air in the clean-air space (1) is conducted, at least in the area of the charging zone (150), as a protective gas stream which is likewise essentially laminar and is parallel to and envelops the wafer support (50).

16. An epitaxial facility according to claim 12 or the following ones, characterized by a device provided in the floor area of the reaction chamber (10) for the snug coupling of the chamber floor structure (11) to a sealing flange (15) formed at the base of the chamber and having at least three elbow lever mechanisms (180), spaced at substantially equal distances about the chamber base, which from beneath grasp by the edges the chamber floor structure brought up by the lift (160) to the sealing flange (15) at the chamber base and, with the help of bevelled guiding surfaces (19) made in the sealing flange (15) and in the chamber floor structure (11), bring it to a tight-fitting sealed position and lock it in that position.

17. An epitaxial facility according to any preceding claim, in which the wafer support (50) comprises indentations (71) to accommodate the wafers (70) which have substantially the form of a segment of a spherical sheel curved in toward the interior of the wafer support, whereby the temperature gradient in the area of the support wall can be taken into account when the support is heated up, characterized in that the said spherical-shell-segment shape of the indentations (71) merges in an essentially continuous manner with the outer surface of the wafer support.

18. An epitaxial facility according to claim 17, characterized by a wafer prop provided in the lower edge area of the indentations (71), protruding slightly from the outer surface of the wafer support.

19. An epitaxial facility according to claim 18, characterized in that the wafer prop consists of two support points (74, 75) located at a distance from one another on a horizontal line.

20. An epitaxial facility according to one of claims 11-19, characterized by a remote-controlled manipulator (300), located in the area of the charging zone (150) and surrounded by a vertical downward flow of pure air, for charging the wafer support (50) with wafers (70) from a wafer storage bin (310) located in the clean-air space (1) and for discharging treated wafers (70) from the wafer support (50) into the wafer storage bin (310), in which the freedom of movement of the manipulator (300) is limited substantially to vertical movements with a view to undisturbed vertical flow of the pure air and laminar flow of the protective gas, at least in the area of the wafer support (50) when it is in the charging zone (150).

21. An epitaxial facility according to claim 20, characterized in that the manipulator (300) is surrounded by a flexible dust protection jacket.

22. An epitaxial facility according to claim 20 or 21, characterized in that the manipulator is a robot arm (300) that can be controlled by the process control computer.

23. An epitaxial facility according to one of claims 20-22, characterized in that for grasping the edge of the wafer, the manipulator (300) comprises a grabbing member with two fingers (301, 302) which are adjustable essentially along a common axis and can be jointly rotated about the edge of the wafer, and that the grabbing member (301, 302) is equipped with an optical detector (320) for detecting a mark on the wafer rim, especially the straight edge section on the wafer (70), the wafer (70) being grasped by the two fingers (301, 302) on the circular arc-shaped wafer edge section by the detector (320), in accord with the edge mark detected optically.

24. An epitaxial facility according to one of claims 20-23, characterized in that the manipulator (300) comprises a further grabbing member (305) with a suction cup, with which wafers (70) deposited in the storage bin can be picked up by their back surface.

25. An epitaxial facility according to one of claims 20-24, in which substantially circular indentations to accommodate the wafers are formed on the wafer support, characterized in that the indentations (71) comprise in their edge area (2) two recesses (72) and (73) placed diagonally opposite one another, dimensioned in such a way that the fingers (301, 302) of the manipulator grabbing member can grasp underneath the edge the wafers (70) placed or to be placed in the indentations (71).

26. Epitaxial facility according to any preceding claim, with a wafer support (50) in the form of a truncated pyramid, characterized in that the wafer support (50) comprises, on its upper and/or basal end, a cap (55) promoting laminar flow or a pedestal (56) promoting laminar flow, respectively.

27. Epitaxial facility according to any preceding claim 1 with a wafer support (50) whose cross section is in the form of a polygon, characterized in that the edges of the wafer support (50) are blunted or rounded.

28. Epitaxial facility according to claim 1, with a computer to command the epitaxial process, characterized in that the computer is arranged so that, after a failure of the facility has occurred, it commands the further processing in accordance with the type of failure that has occurred.

## Revendications

1. Installation d'épitaxie pour l'application de couches semi-conductrices sur des plaquettes semi-conductrices (70), avec au moins une chambre de réaction (10) pour recevoir un support de plaquettes rotatif (50) en forme de pyramide tronquée pour porter les plaquettes, la chambre étant munie d'au moins une entrée et d'une sortie de gaz pour amener et évacuer des gaz vecteurs, réactifs, de vidange, d'air pur et/ou des gaz de protection, un mélangeur de gaz (100) pour mélanger les gaz étant placé en amont de l'entrée de gaz, caractérisée en ce que l'installation comprend une paire de chambres de réaction (10, 10') agencées de façon identique en ce qui concerne les connexions, les flux et le maniement, et qui sont agencées pour que les supports de plaquettes (50) puissent être garnis indépendamment et pour que les deux chambres de réaction puissent fonctionner en épitaxie de manière indépendante, que le mélangeur de gaz (100) comporte une conduite de gaz principale (101) connectée aux entrées de gaz des chambres de réaction (10, 10') par l'intermédiaire d'un branchement symétrique, ainsi que plusieurs branches (102, 107, 110) annexes débouchant successivement à la manière de registres dans la conduite principale (101) pour l'alimentation en gaz de réaction et de vidange, ces différents gaz étant déversés, lors du fonctionnement de l'installation, dans les branches se succédant à la manière de registres en fonction de leur pureté technique et de leur agressivité et de façon à ce que les gaz les moins purs et les plus agressifs soient déversés en priorité dans les branches annexes les plus proches de la sortie de gaz (108, 109) du mélangeur (100), et qu'au moins chacune des deux branches (107, 110) débouchant le plus en aval dans la conduite principale par une paire de canaux débouchant de manière symétrique dans celle-ci.

2. Installation d'épitaxie selon la revendication 1, caractérisée en ce que lors de son fonctionnement le gaz vecteur est amené par l'extrémité (99) de la conduite principale (101) située à l'opposé de la sortie (108, 109) du mélangeur (100).

3. Installation d'épitaxie selon une des revendications 1 ou 2, caractérisée en ce que lors de son fonctionnement le gaz de vidange est amené dans la conduite principale (101) par une conduite (107) à proximité immédiate de la sortie (108, 109) du mélangeur (100).

4. Installation d'épitaxie selon une des revendications précédentes, caractérisée en ce que l'entrée de gaz consiste en un diffuseur de gaz (120) coaxial avec l'axe longitudinal du support rotatif (50) de plaquettes et réglable le long de cet axe longitudinal de manière à ce que le profil du flux de gaz pénétrant dans la chambre de réaction (10) à partir du diffuseur (120) se transforme essentiellement sans turbulence en un profil de flux qui s'écoule entre la paroi intérieure de la chambre et le contour du support de plaquettes.

5. Installation d'épitaxie selon la revendication 4, avec une chambre de réaction (10) essentiellement en forme de cloche, caractérisée en ce que le diffuseur de gaz (120) présente essentiellement la forme d'un pilon circulaire dont la tige s'étend dans le goulot d'entrée (21) de la chambre de réaction (10) et dont le fond circulaire fait face à l'extrémité supérieure du support de plaquettes et comporte des sorties de gaz réparties radialement.

6. Installation d'épitaxie selon la revendication 5, caractérisée en ce que le diffuseur de gaz (120) comporte, dans la région de la tige d'un pilon une plaque directrice de courant (124) apte à empêcher l'entrée dans le goulot d'amenée du gaz du flux de gaz circulant dans la chambre de réaction (10).

7. Installation d'épitaxie selon une des revendications précédentes, caractérisée en ce que l'axe longitudinal du support de plaquettes et l'amenée de gaz dans le plafond (20) de la chambre de réaction (10) sont coaxiaux avec l'axe longitudinal de la chambre.

8. Installation d'épitaxie selon une des revendications précédentes, caractérisée par une pièce annulaire (200) posée sur le fond (11) de la chambre de réaction (10) et s'étendant jusqu'à proximité de sa paroi intérieure, cette pièce entourant la base du support de plaquettes (50) de façon à ce que les orifices de sortie de gaz (12) prévus dans le fond (11) de la chambre se trouvent dans l'espace annulaire situé entre la paroi intérieure de la pièce annulaire (200) et la paroi extérieure du socle du support.

9. Installation d'épitaxie selon la revendication 8, caractérisée en ce que les orifices de sortie de gaz (12) agencés dans le fond (11) de la chambre débouchent dans un espace (210) formant un piège à particules.

10. Installation d'épitaxie selon la revendication 9, caractérisée en ce que l'espace formant piège à particules est composé d'un canal circulaire (21) entourant un dispositif d'entraînement en rotation du support de plaquettes, limité du côté supérieur par le fond (11) de la chambre avec ses orifices de sortie, et du côté inférieur par un fond (215) également muni d'orifices (216), ces derniers étant connectés avec les conduites de sortie du gaz.

11. Installation d'épitaxie selon une des revendications précédentes, avec un dispositif (160) pour transporter le support de plaquettes (50) entre une zone de chargement (150) située hors de la chambre de réaction (10) et une position de travail à l'intérieur de celle-ci, avec un dispositif (300) pour le chargement et le déchargement des plaquettes (70) sur le support de plaquettes (50), et avec une enceinte (1) à air pur dans laquelle sont placés ces dispositifs (160, 300), caractérisée en ce que les moyens auxiliaires sont aussi agencés pour faire passer de l'air pur et des gaz de protection à travers l'enceinte (1).

12. Installation d'épitaxie selon la revendication 11, caractérisée en ce que le dispositif de transfert est un ascenseur (160) pour mouvoir verticalement le support de plaquettes (50) en même temps que le fond (11) de la chambre de réaction (10) et la zone de chargement (150) située sous la chambre de réaction (10).

13. Installation d'épitaxie selon une des revendications 11 ou 12, caractérisée par des moyens auxiliaires agencés et disposés pour assurer un courant essentiellement laminaire de gaz de protection autour du support de plaquettes (50) lors de son transfert entre la zone de chargement (150) et la position de travail dans la chambre de réaction (10) et/ou lors d'un séjour dans la zone de chargement (150).

14. Installation d'épitaxie selon la revendication 13, caractérisée en ce que le courant laminaire de gaz de protection est formé par un gaz de vidange introduit dans la chambre de réaction (10) à partir du mélangeur (100), ce gaz parcourant la chambre de réaction (10) de l'entrée de gaz située à son plafond (20) jusqu'à la base ouverte de la chambre et entourant le support de plaquettes (50) d'un courant essentiellement laminaire.

15. Installation d'épitaxie selon une des revendications 11 ou suivantes, caractérisée en ce que le courant d'air pur dans l'enceinte à air pur (1) est également formé pour l'essentiel et au moins dans la zone de chargement (150) d'un courant de gaz de protection essentiellement laminaire, parallèle au support de plaquettes (50), et entourant celui-ci.

16. Installation d'épitaxie selon une des revendications 12 ou suivantes, caractérisée par un dispositif prévu à proximité du fond de la chambre de réaction (10) pour accoupler sans jeu le fond (11) de la chambre à un flasque d'étanchéité (15) formé à la base de la chambre, comprenant au moins trois mécanismes à levier (180) répartis de façon essentiellement régulière autour de la base de la chambre et qui saisissent le fond de la chambre sur son bord et par-dessous, lorsque l'ascenseur (160) l'a amené à proximité de la base de la chambre, l'ajustent en une position de fermeture hermétique au moyen de surfaces de positionnement obliques (19) formées dans le fond (11) de la chambre, et le bloquent en cette position.

17. Installation d'épitaxie selon une des revendications précédentes, où le support de plaquettes (50) comporte des creux (71) pour recevoir les plaquettes (70), ces creux présentant essentiellement la forme d'une calotte sphérique courbée vers l'intérieur du support pour tenir compte du gradient de température au voisinage de la paroi du support lorsque celui-ci est chauffé, caractérisée par une transition essentiellement continue de cette forme en calotte (71) vers la surface extérieure du support de plaquettes.

18. Installation d'épitaxie selon la revendication 17, caractérisée par un appui protubérant légèrement de la surface extérieure du support à la partie inférieure du bord des creux (71), pour porter les plaquettes.

19. Installation d'épitaxie selon la revendication 18, caractérisée en ce que l'appui consiste en deux points d'appui (74, 75) situés à l'horizontale et à distance l'un de l'autre.

20. Installation d'épitaxie selon une des revendications 11 à 19, caractérisée par un manipulateur (300) télécommandé placé dans le domaine de la zone de chargement (150) et entouré d'un courant d'air pur s'écoulant de haut en bas, pour garnir le support de plaquettes (50) avec des plaquettes (70) provenant d'une réserve (310) de plaquettes située dans l'enceinte à air purifié (1), ainsi que pour décharger des plaquettes (70) traitées du support (50) et les amener à la réserve (310), les mouvements du manipulateur (300) étant limités pour l'essentiel à des mouvements verticaux, pour assurer un courant vertical non-perturbé de l'air pur ainsi qu'un courant laminaire du gaz de protection, au moins dans la région de la zone de chargement où se trouve le support de plaquettes (50).

21. Installation d'épitaxie selon la revendication 20, caractérisée en ce que le manipulateur (300) est recouvert d'une housse de protection souple contre la poussière.

22. Installation d'épitaxie selon une des revendications 20 ou 21, caractérisée en ce que le manipulateur est un bras-robot (300) commandé par le calculateur.

23. Installation d'épitaxie selon une des revendications 20 à 22, caractérisée en ce que le manipulateur (300) comporte un organe de préhension muni de deux doigts (301, 302) pour saisir le bord de la plaquette, ces doigts étant essentiellement réglables le long d'un axe commun et pouvant tourner ensemble autour du bord de la plaquette, et en ce que l'organe de préhension (301, 302) est muni d'un détecteur optique (320) pour détecter une marque sur le bord de la plaquette, et en particulier de la partie rectiligne du bord de la plaquette (70), celle-ci étant saisie par les deux doigts (301, 302) le long de la partie curviligne de son bord, conformément à la marque détectée optiquement par le détecteur (320).

24. Installation d'épitaxie selon une des revendications 20 à 23, caractérisée en ce que le manipulateur (300) comprend un second organe de préhension (305) comportant une ventouse et capable de saisir des plaquettes (70) déposées dans la réserve par leur surface postérieure.

25. Installation d'épitaxie selon une des revendications 20 à 24, des creux essentiellement circulaires pour recevoir les plaquettes étant formés sur le support de plaquettes, caractérisée en ce que les creux (71) présentent à leurs bords (2) deux cavités (72, 73) diagonalement opposées et dimensionnées de manière à ce que les doigts (301, 302) de l'organe de préhension du manipulateur puissent s'insérer sous le bord des plaquettes placées dans les creux (71), ou devant être placées dans ceux-ci.

26. Installation d'épitaxie selon une des revendications précédentes, avec un support de plaquettes (50) en forme de pyramide tronquée, caractérisée en ce que le support (50) comporte à son extrémité supérieure et/ou à sa base un couvercle (55) respectivement un socle (56) facilitant un écoulement laminaire.

27. Installation d'épitaxie selon une des revendications précédentes, avec un support de plaquettes (50) dont la coupe transversale a la forme d'un polygone, caractérisée en ce que les arêtes du support de plaquettes (50) sont arrondies ou tronquées.

28. Installation d'épitaxie selon la revendication 1, avec un ordinateur pour la commande du processus d'épitaxie, caractérisée en ce que l'ordinateur est agencé pour commander, après une défaillance de fonctionnement, le déroulement du processus en fonction de la défaillance en question.
